# FASCICULE DE BREVET EUROPEEN

(11) **EP 3 624 299 B1**
(45) Date de publication et mention de la délivrance du brevet: **28.07.2021**
(21) Numéro de dépôt: 19196715.7
(22) Date de dépôt: 11.09.2019
(51) Int. Cl.: H02J 7/00, H01H 37/58, H01H 37/32

(54) **PACK-BATTERIE D'ACCUMULATEURS ÉLECTROCHIMIQUES COMPRENANT DES DISPOSITIFS DE DECONNEXION MAGNÉTIQUE PASSIVE ENTRE LES ACCUMULATEURS ET DES BUSBARS, ET LE CAS ÉCHEANT DE SHUNT PASSIF D'UN OU PLUSIEURS ACCUMULATEURS EN CAS DE DÉFAILLANCE D'UN DE CEUX-CI**
BATTERIEPAKET AUS ELEKTROCHEMISCHEN AKKUS, DAS VORRICHTUNGEN ZUR PASSIVEN MAGNETISCHEN TRENNUNG ZWISCHEN DEN AKKUS UND DEN SAMMELSCHIENEN UMFASST, UND GEGEBENENFALLS EINEN PASSIVEN NEBENSCHLUSS VON EINEM ODER MEHREREN AKKUS IM FALLE EINES AUSFALLS VON EINEM VON IHNEN
BATTERY PACK OF ELECTROCHEMICAL STORAGE CELLS COMPRISING DEVICES FOR PASSIVE MAGNETIC DISCONNECTION BETWEEN THE STORAGE CELLS AND BUSBARS AND, WHERE APPLICABLE, PASSIVE SHUNT OF ONE OR MORE STORAGE CELLS IN THE EVENT OF FAILURE OF ONE OF THEM

(30) Priorité: 12.09.2018 FR 1858188
(43) Date de publication de la demande: 18.03.2020
(73) Titulaire: Commissariat à l'Energie Atomique et aux Energies Alternatives, 75015 Paris (FR)
(72) Inventeur: LEJOSNE, Johann, 38054 GRENOBLE CEDEX 9 (FR); JOST, Pierre, 38054 GRENOBLE CEDEX 9 (FR); PERICHON, Pierre, 38054 GRENOBLE CEDEX 9 (FR)
(74) Mandataire: Nony

(56) Documents cités:
- KR-A- 20140 039 451
- US-A1- 2011 223 776

## Description

### Domaine technique

La présente invention concerne le domaine des batteries ou accumulateurs métal-ion ou autres chimies (plomb...).

L'invention vise en premier lieu à améliorer l'assemblage, le coût et la sécurité afférents d'un pack-batterie à pluralité de batteries ou accumulateurs avec des barres de connexion électrique, dites busbars.

Pour cela, l'invention propose des dispositifs de connexion/déconnexion et le cas échéant de shunt par verrouillage/déverrouillage magnétique pour chaque accumulateur unitaire ou pour une branche d'accumulateurs au sein d'un pack-batterie.

Ces dispositifs par verrouillage/déverrouillage magnétique permettent en outre d'obtenir un pilotage actif ou passif du pack-batterie par un ou plusieurs systèmes de contrôle électronique (BMS), notamment afin de moduler la puissance effective du pack ainsi que de garantir une sécurité et une continuité de fonctionnement du pack en cas de défaillance d'un ou plusieurs accumulateurs.

Bien que décrite en référence à un accumulateur Lithium-ion, l'invention s'applique à tout accumulateur électrochimique métal-ion, c'est-à-dire également Sodium-ion, Magnésium-ion, Aluminium-ion, voire d'autres chimies (Plomb..)...

### Art antérieur

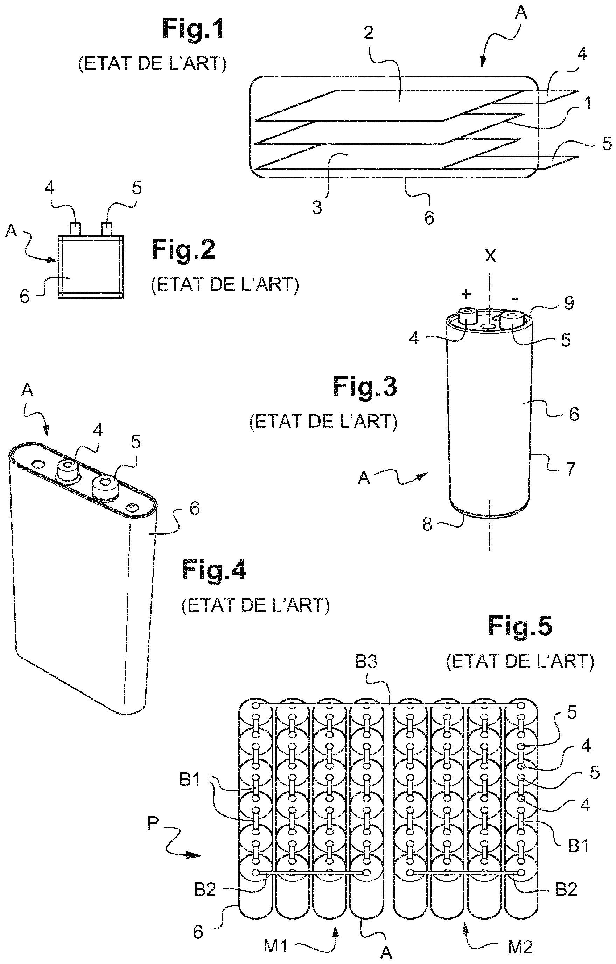

Telle qu'illustrée schématiquement en figures 1 et 2, une batterie ou accumulateur lithium-ion comporte usuellement au moins une cellule électrochimique C constituée d'un constituant séparateur imprégné d'électrolyte 1 entre une électrode positive ou cathode 2 et une électrode négative ou anode 3, un collecteur de courant 4 connecté à la cathode 2, un collecteur de courant 5 connecté à 1' anode 3 et enfin, un emballage 6 agencé pour contenir la cellule électrochimique avec étanchéité tout en étant traversé par une partie des collecteurs de courant 4, 5.

Plusieurs types de géométrie d'architecture d'accumulateur sont connus :
- une géométrie cylindrique telle que divulguée dans la demande de brevet US 2006/0121348,
- une géométrie prismatique telle que divulguée dans les brevets US 7348098, US 7338733;
- une géométrie en empilement telle que divulguée dans les demandes de brevet US 2008/060189, US 2008/0057392, et brevet US 7335448.

Le constituant d'électrolyte 1 peut être de forme solide, liquide ou gel. Sous cette dernière forme, le constituant peut comprendre un séparateur en polymère, en céramique ou en composite microporeux imbibé d'électrolyte (s) organique (s) ou de type liquide ionique qui permet le déplacement de l'ion Lithium de la cathode à l'anode pour une charge et inversement pour une décharge, ce qui génère le courant. L'électrolyte est en général un mélange de solvants organiques, par exemple des carbonates dans lesquels est ajouté un sel de lithium typiquement LiPF6.

L'électrode positive ou cathode 2 est constituée de matériaux d'insertion du cation Lithium qui sont en général composite, comme LiFePO₄, LiCoO₂, LiNi_{0.33}Mn_{0.33} Co_{0.33} O₂.

L'électrode négative ou anode 3 est très souvent constituée de carbone graphite ou en Li₄TiO₅O₁₂ (matériau titanate), éventuellement également à base de silicium ou de composite formé à base de silicium.

Le collecteur de courant 4 connecté à l'électrode positive est en général en aluminium.

Le collecteur de courant 5 connecté à l'électrode négative est en général en cuivre, en cuivre nickelé ou en aluminium.

Une batterie ou accumulateur lithium-ion peut comporter bien évidemment une pluralité de cellules électrochimiques qui sont empilées les unes sur les autres.

Traditionnellement, une batterie ou accumulateur Li-ion utilise un couple de matériaux à l'anode et à la cathode lui permettant de fonctionner à un niveau de tension élevé, typiquement égal à 3,6 Volt.

Selon le type d'application visée, on cherche à réaliser soit un accumulateur lithium-ion fin et flexible soit un accumulateur rigide : l'emballage est alors soit souple soit rigide et constitue dans ce dernier cas en quelque sorte un boitier.

Les emballages souples sont usuellement fabriqués à partir d'un matériau composite multicouches, constitué d'un empilement de couches d'aluminium recouvertes par un ou plusieurs film(s) en polymère laminés par collage.

Les emballages rigides sont quant à eux utilisés lorsque les applications visées sont contraignantes où l'on cherche une longue durée de vie, avec par exemple des pressions à supporter bien supérieures et un niveau d'étanchéité requis plus strict, typiquement inférieure à 10⁻⁸ mbar.l/s, ou dans des milieux à fortes contraintes comme le domaine aéronautique ou spatial.

Aussi, à ce jour un emballage rigide utilisé est constitué d'un boitier, généralement en métal, typiquement en acier inoxydable (inox 316L ou inox 304) ou en aluminium (Al 1050 ou Al 3003), ou encore en titane. En outre, l'aluminium est généralement préféré pour son coefficient de conductivité thermique élevé comme expliqué ci-après.

La géométrie de la plupart des boitiers rigides d'emballages d'accumulateurs Li-ion est cylindrique, car la plupart des cellules électrochimiques des accumulateurs sont enroulées par bobinage selon une géométrie cylindrique autour d'un mandrin cylindrique. Des formes prismatiques de boitiers ont également déjà été réalisées par bobinage autour d'un mandrin prismatique.

Un des types de boitier rigide de forme cylindrique, usuellement fabriqué pour un accumulateur Li-ion de forte capacité, est illustré en figure 3.

Un boitier rigide de forme prismatique est également montré en figure 4.

Le boitier 6 comporte une enveloppe latérale cylindrique 7, un fond 8 à une extrémité, un couvercle 9 à l'autre extrémité, le fond 8 et le couvercle 9 étant assemblés à l'enveloppe 7. Le couvercle 9 supporte les pôles ou bornes de sortie du courant 4, 5. Une des bornes de sortie (pôles), par exemple la borne positive 4 est soudée sur le couvercle 9 tandis que l'autre borne de sortie, par exemple la borne négative 5, passe à travers le couvercle 9 avec interposition d'un joint non représenté qui isole électriquement la borne négative 5 du couvercle.

Le type de boitier rigide largement fabriqué consiste également en un godet embouti et un couvercle, soudés entre eux sur leur périphérie par laser. En revanche, les collecteurs de courant comprennent une traversée avec une partie faisant saillie sur le dessus du boitier et qui forme une borne aussi appelée pôle apparent de la batterie.

La difficulté de réalisation d'une telle borne réside principalement dans l'assemblage des différents composants de la batterie afin d'avoir un design robuste. La nature des matériaux utilisée est également importante afin d'être compatible avec certains couples électrochimiques. En effet, la technologie Li-ion nécessite de préférence à sélectionner un grade d'aluminium le plus pur possible à l'intérieur de l'accumulateur pour éviter la présence de pollutions et la génération de couple galvaniques en présence de l'électrolyte pouvant mener à de la corrosion.

En outre, une borne en traversée étanche doit être robuste mécaniquement et respecter les conditions suivantes:
- ne pas se déformer au cours des étapes d'assemblage de l'accumulateur ;
- permettre l'assemblage de l'accumulateur avec un busbar et assurer le passage du courant avec ce dernier ;
- rester intègre pendant toute la durée de vie d'un accumulateur dans son application, c'est-à-dire résister aux vibrations, chocs mécaniques, variations de températures et de pression.., sans déformation et sans fuite ;
- permettre de drainer des courants élevés pouvant dépasser 50A, dans le cas d'un accumulateur seul, de capacité inférieure à 5Ah nominale, afin de pouvoir être utilisé dans des applications de puissance.

Généralement, les traversées étanches formant les bornes de sortie d'accumulateurs Li-ion, sont en cuivre nickelé car l'électrode négative est très souvent composée de graphite donc enduite sur du cuivre mais peuvent être également en aluminium pour des matériaux tel que le titanate, le sodium ou le silicium qui ont comme particularités d'être enduit sur un substrat d'aluminium.

La demande de brevet FR2989836 divulgue une traversée formant une borne de sortie d'un accumulateur métal-ion qui permet de faire circuler des courants très élevés, typiquement de l'ordre de 100A.

Un pack batterie P est constitué d'un nombre variable d'accumulateurs pouvant atteindre plusieurs milliers qui sont reliés électriquement en série ou en parallèle entre eux et généralement par des barres ou pistes de connexion mécanique et électrique, appelées usuellement, busbars.

D'une manière générale, plusieurs architectures électriques peuvent être définies au sein d'un pack-batterie P. Ainsi, des accumulateurs peuvent être reliés entre eux en parallèle, c'est-à-dire avec toutes les bornes positives reliées entre elles et toutes les bornes négatives également reliées entre elles. Ces liaisons forment une branche qui peut être reliée en série à une autre branche. On peut aussi avoir des accumulateurs reliés entre eux en série, c'est-à-dire que les bornes positives sont reliées aux bornes négatives. Ces liaisons forment une branche qui peut être reliée en parallèle à une autre branche.

Quelle que soit l'architecture, chaque branche en série ou en parallèle peut comporter généralement de deux à des dizaines d'accumulateurs.

Les accumulateurs des packs batterie actuels sont généralement assemblés sur un ou plusieurs busbars par soudage, vissage ou frettage.

Un exemple de pack-batterie P est montré en figure 5. Ce pack est constitué de deux modules M1, M2 d'accumulateurs Li-ion A identiques et reliés entre eux en série, chaque module M1, M2 étant constitué de quatre rangées d'accumulateurs reliés en parallèle, chaque rangée étant constituée d'un nombre égal à six accumulateurs Li-ion.

Comme représenté, la connexion mécanique et électrique entre deux accumulateurs Li-ion d'une même rangée est réalisée par vissage de busbars B1, avantageusement en cuivre, reliant chacune une borne positive 4 à une borne négative 5. La connexion entre deux rangées d'accumulateurs en parallèle au sein d'un même module M1 ou M2 est assurée par un busbar B2, également avantageusement en cuivre. La connexion entre les deux modules M1, M2 est assurée par un busbar B3, également avantageusement en cuivre.

Un tel assemblage est relativement long avec des coûts de production relativement élevés.

En outre, les accumulateurs sous tension qui doivent être manipulés nécessitent l'obtention pour les opérateurs d'habilitations contraignantes, de type TST.

Le brevet CN 2285515 présente un support magnétique pour accumulateur de petite tension qui présente l'avantage d'une mise en connexion rapide sans serrage de l'accumulateur. Cette fixation peut être utilisée pour différentes applications de charge/décharge... avec des accumulateurs de faibles énergies. Mais, il n'est pas compatible avec des accumulateurs à hautes tensions mises en série sur un busbar au sein d'un pack-batterie.

Dans le développement et la fabrication des batteries lithium-ion, pour chaque profil de charge/décharge spécifique à chaque nouvelle demande, quels que soient les acteurs du marché, cela nécessite des dimensionnements précis (architectures électriques série/parallèle, mécaniques, thermiques...) pour concevoir de manière optimale un pack-batterie performant et sécuritaire.

Un système électrochimique lithium, que ce soit à l'échelle cellule, module ou pack, produit des réactions exothermiques quel que soit le profil de cyclage donné. Ainsi, à l'échelle d'un accumulateur unitaire, en fonction des chimies considérées, le fonctionnement optimal des accumulateurs lithium ion est limité dans une certaine gamme de température.

Un accumulateur doit contrôler sa température, typiquement généralement inférieure à 70°C à sa surface extérieure de boitier, afin d'éviter de partir en emballement thermique qui peut être suivi d'une génération de gaz et d'explosion et/ou feu.

Également, le maintien d'une température inférieure à 70°C permet d'augmenter sa durée de vie, car plus la température de fonctionnement d'un accumulateur est élevée, plus sa durée de vie sera diminuée.

En outre, certaines chimies d'accumulateurs requièrent une température de fonctionnement bien au-delà de la température ambiante et par conséquent, il s'avère nécessaire de réguler leur niveau de température par un préchauffage initial des accumulateurs, voire par un maintien en température permanent des accumulateurs.

Dans une batterie, ou pack-batterie à plusieurs accumulateurs Li-ion à hautes énergies, typiquement supérieure à 1kW.h, plusieurs accumulateurs sont mis en série pour obtenir le niveau de tension requis et de mise en parallèle pour obtenir le courant à fournir. La mise en série/parallèle peut se faire au niveau des accumulateurs, des modules avec une grande variété de topologies de câblage.

La mise en série ou parallèle d'accumulateurs plus ou moins différents peut avoir des conséquences sur les performances et durabilité résultantes pour le pack.

Il est ainsi reconnu que dans un pack-batterie, par exemple de véhicule électrique, les dispersions de vieillissements peuvent être élevées en fonction par exemple de la position des accumulateurs, par suite de dissymétries de vieillissement entre les accumulateurs ou des différences d'utilisations (variations thermiques entre le cœur et les bords du pack, gradient de courant...). Ainsi, des écarts d'états de santé SOH de l'ordre de 20% entre accumulateurs d'un même pack peuvent être observés.

Aussi, afin de limiter le vieillissement prématuré du pack, il est nécessaire d'optimiser la température de fonctionnement et la dispersion de température d'un accumulateur à l'autre. Un accumulateur (ou des accumulateurs) qui vieillit (vieillissent) plus vite que les autres peut (peuvent) avoir un impact direct sur les performances électriques du pack-batterie complet.

De manière générale, une défaillance d'un accumulateur dans un pack batterie peut avoir plusieurs impacts :
- le dégagement, d'une part, de l'énergie stockée dans l'accumulateur en défaut et, d'autre part, de l'énergie d'autres accumulateurs du pack. Selon la topologie choisie pour le pack, l'énergie apportée par les autres accumulateurs du pack peut amener un risque de feu ou d'explosion qui n'existait pas sur l'accumulateur seul ;
- des réactions électrochimiques au cœur des accumulateurs peuvent conduire à la destruction des accumulateurs unitaires et provoquer une propagation d'un défaut interne à l'accumulateur (généralement un court-circuit interne) conduisant à l'explosion du pack. L'énergie de dégradation des composants internes peut ainsi être élevée. Dans ce cas, il est également nécessaire d'avoir recours à un système de pilotage (BMS) afin de protéger les autres cellules du pack, comme précisé ci-après
- le pack complet ne peut plus être utilisé pour l'application ou être en mode dégradé (énergie plus faible par exemple). Ainsi, si un défaut d'un accumulateur dans un pack est constaté, il est important de l'isoler rapidement, le rendre inerte, et assurer une continuité de service du pack restant. Par exemple, une batterie lithium ion d'APU intégré dans un aéronef ne doit pas perturber le fonctionnement du dit aéronef et assurer une sécurité optimale pendant le vol.

Il a déjà été proposé de réaliser un by-pass d'un accumulateur métal ion défaillant au sein d'un pack-batterie.

Ainsi, le brevet US 5438173 présente un capteur capable de réaliser un tel by pass : ce capteur permet de détecter une défaillance de la batterie et un commutateur ouvre alors automatiquement un autre chemin électrique autour de l'accumulateur défaillant, en contournant la défaillance et en permettant au reste du système de batterie de continuer à fonctionner. Le commutateur de dérivation de l'accumulateur est conçu pour être placé en parallèle avec l'accumulateur qu'il protège. Ce commutateur comprend deux ensembles d'actionneurs électromécaniques qui sont montés sur l'extrémité supérieure du boîtier d'accumulateur pour actionner deux pistons. Chacun des actionneurs électromécaniques comprend deux moitiés de bobine qui sont maintenues ensemble par un enroulement serré d'un fil de retenue qui se termine par un fil de pont reliant deux bornes électriques d'un actionneur. Chaque bobine, grâce à l'enroulement du fil de retenue, peut retenir un plongeur à ressort. Quand un courant électrique suffisant passe à travers les bornes et le fil de pont, ce dernier chauffe et se casse, ce qui provoque le déroulement du fil de retenue, et par là la séparation des bobines et donc la libération du piston.

De fait, ce système mécanique décrit dans ce brevet est complexe à mettre en œuvre et ne permet pas de détecter la défaillance par l'accumulateur lui-même.

Le brevet US6093896 présente un système analogue avec les mêmes inconvénients, qui permet d'établir une dérivation automatique d'un accumulateur défaillant connecté en série au sein d'un pack batterie.

Autrement dit, à ce jour, l'ensemble des systèmes de bypass d'accumulateur défaillants au sein d'un pack batterie, qui ont été proposés, sont mécaniques avec généralement un capteur de défaut de l'accumulateur qui actionne une dérivation électrique du circuit.

Aussi, il n'existe pas à ce jour ni de système propre à un accumulateur pour le shunter et assurer une continuité de fonctionnement d'un pack-batterie, ni de système de déconnexion d'un accumulateur du bus-bar d'un pack batterie à haute tension, typiquement de plusieurs kW, et à fortiori de système conjuguant la déconnexion et l'inertage d'un accumulateur défaillant, afin d'éviter une propagation thermique du défaut au reste du pack.

Par « inertage », on entend ici et dans le cadre de l'invention, le fait d'arrêter l'emballement d'un accumulateur qui est généré par des réactions électrochimiques non souhaitées au sein de l'accumulateur.

Par ailleurs, à l'échelle du module et du pack, typiquement en dessous de 0°C par exemple, il peut être nécessaire d'avoir recours à un pilotage particulier via un BMS, afin de limiter la puissance demandée au pack et d'éviter une dégradation des accumulateurs.

On rappelle ici que le BMS (acronyme anglais de « *Battery Management System* ») est utilisé afin de suivre l'état des différents accumulateurs (tension totale ou de chaque accumulateur, température, état de charge, profondeur de décharge, état de santé, débit du fluide de refroidissement, valeur du courant...) et de piloter les différents éléments de sécurité , tels des courants ne devant pas être trop élevés, des potentiels non adaptés (trop élevés ou trop faibles), des températures limites et a donc notamment pour fonction d'arrêter la fourniture de courant dès l'atteinte de valeurs de tension seuil, i.e. une différence de potentiels entre les deux matériaux d'insertion actifs. Le BMS stoppe donc le fonctionnement (charge, décharge) dès l'atteinte de tensions seuils. Un BMS surveille l'état des différents éléments d'un pack-batterie, tels que :
- la tension totale ou celle des accumulateurs individuels,
- la température, c'est-à-dire au moins une des températures choisies parmi la température moyenne, la température d'admission de liquide de refroidissement, la température de sortie de liquide de refroidissement, ou la température de chaque accumulateur,
- l'état de charge (SOC) ou la profondeur de décharge (DOD) qui indique le niveau de charge du pack,
- l'état de santé (SOH) qui est une mesure définie de l'état général du pack,
- le débit du fluide caloporteur pour le refroidissement de tout ou partie du pack,
- le courant électrique au sein ou hors du pack, ...

Au-delà d'une température supérieure, typiquement de l'ordre 70°C, il convient également d'être vigilant car des réactions électrochimiques peuvent conduire à la destruction des accumulateurs unitaires et provoquer une propagation d'un défaut interne à l'accumulateur, typiquement un court-circuit interne, au reste des composants du pack-batterie, ce qui peut conduire à l'extrême à l'explosion du pack. Dans ce cas, il est également nécessaire d'avoir recours au BMS, afin de protéger les accumulateurs. Par conséquent, un pack-batterie nécessite généralement au moins un BMS très performant, afin de générer des équilibrages de tension. Dans un pack-batterie, il peut y avoir un unique ou bien plusieurs BMS au sein du pack, voire un BMS par accumulateur.

De manière générale, il a déjà été proposé des solutions de pilotage d'un pack-batterie par le BMS pour commuter à la demande des accumulateurs du pack.

La demande de brevet FR2972306 propose ainsi un dispositif de gestion des accumulateurs élémentaires d'une batterie pour optimiser la charge et l'utilisation de la batterie. Chaque accumulateur élémentaire d'un étage peut être piloté sur la base d'une information mesurée localement au sein même de cet étage.

Le brevet FR2972307B1 divulgue une batterie comprenant des moyens de commande locale d'un interrupteur associé à la cellule électrochimique élémentaire de la batterie. Le circuit de commande des transistors de puissance est alimenté directement par la tension disponible au niveau de l'étage correspondant.

Également, le brevet FR2926168B1 propose un circuit électrique, destiné notamment à des véhicules automobiles, qui comporte un réseau de bord, alimentant des organes consommateurs, un moyen générateur d'énergie électrique, et au moins un moyen de stockage électrique commutable comportant des éléments aptes à fournir une tension variable, qui peuvent en outre être commutés successivement de sorte que le moyen de stockage électrique commutable peut fournir une tension régulée.

L'ensemble de ces brevets propose donc de dispositifs électroniques/électriques permettant la commutation qui ont notamment plusieurs fonctions de supervision. Mais ils peuvent être complexes, nécessitent de nombreuses redondances qui sont coûteuses et sont dépendant de l'électronique.

La demande de brevet US2011/223776 divulgue un système d'interconnexion modulaire permettant de connecter une pluralité de cellules, telles que des cellules d'accumulateurs ou de panneaux solaires, de manière à ce qu'elles puissent être déconnectées, grâce à l'utilisation de matériaux magnétiques.

En résumé, il existe un besoin d'améliorer :
- les solutions d'assemblage des accumulateurs métal-ion à des bus-bars, notamment afin de réduire le temps et leur coût d'assemblage ;
- les solutions de déconnexion et de shunt d'un ou plusieurs accumulateurs défaillant au sein d'un pack-batterie, tout en garantissant la continuité de fonctionnement de ce dernier en toute sécurité ;
- les pilotages à la demande du circuit électrique de pack-batterie, notamment afin de les rendre plus simple avec moins de redondance et à moindre coût.

Le but de l'invention est de répondre au moins en partie à ces besoins.

### Exposé de l'invention

Pour ce faire, l'invention concerne, sous l'un de ses aspects, un pack-batterie (P) comprenant :
- une pluralité de batteries ou d'accumulateurs électrochimiques, comprenant chacun :
   - un boitier ou un emballage souple,
   - une première borne de sortie et une deuxième borne de sortie de polarité opposée à la première borne de sortie;
   au moins une des bornes de sortie comprenant:
   - une pièce électriquement conductrice,
   - un verrou magnétique comprenant un aimant permanent;
- au moins une pièce ferromagnétique solidaire d'une barre de connexion électrique, dite busbar, formant une plaque de fermeture d'un circuit magnétique avec le verrou magnétique de la borne de sortie ;
   le pack-batterie étant configuré de sorte que :
   i/ lors d'un fonctionnement normal de l'accumulateur, la force magnétique d'attraction de 1' aimant permanent de la borne de sortie sur la plaque de fermeture d'un premier busbar, dans la configuration des circuits magnétiques fermés, assure la connexion mécanique et électrique entre la borne de sortie et le premier busbar,
   ii/ lors d'une défaillance de l'accumulateur provoquant une surchauffe de ce dernier, l'aimant permanent de la borne de sortie chauffe et au moins jusqu'à une température à partir de laquelle il perd ses propriétés magnétiques, jusqu'à la déconnexion mécanique entre la borne de sortie et le premier busbar, ce qui provoque une chute par gravité de l'accumulateur.

La température peut être la température dite de Curie.

Ainsi, l'invention consiste essentiellement en un pack-batterie au sein duquel chaque accumulateur est connecté mécaniquement et électriquement par un dispositif magnétique à un busbar. En cas de défaillance de n'importe quel accumulateur, celui-ci est déconnecté complètement de manière passive car sa défaillance génère une inactivation du dispositif magnétique. La déconnexion entraîne la chute par gravité de l'accumulateur et la mise en œuvre éventuellement complètement passive d'un shunt de l'accumulateur.

Selon un mode de réalisation avantageux, le pack-batterie comprend:
- au moins une lame électriquement conductrice, flexible, fixée à l'une de ses extrémités à un autre busbar ou autre partie de busbars, comprenant un aimant permanent ;
   le pack-batterie étant configuré de sorte que :
   lors de l'étape i/, l'aimant permanent de la lame flexible est répulsé par celui de la borne de sortie tel que la lame flexible ne peut pas être en contact électrique avec le premier busbar,
   lors de l'étape ii/, du fait de l'absence de répulsion magnétique de l'accumulateur défaillant ayant chuté, la connexion électrique entre le premier et le l'autre busbar par le biais respectivement de la lame flexible, qui réalise par-là le shunt de l'accumulateur.

Par « lame flexible », on entend ici et dans le cadre de l'invention, une lame adaptée pour se déformer en flexion de quelques mm, pour assurer le passage d'une connexion à une déconnexion électrique.

Par « lame rigide », on entend ici et dans le cadre de l'invention, une lame qui ne subit pas de déformation par flexion pour la connexion mais une rotation autour de son point d'articulation.

Selon un mode de réalisation avantageux, la température de Curie de l'aimant permanent étant choisie pour être comprise entre une valeur proche de 90% de la température d'auto-échauffement (T1) et une valeur proche de 110% de la température d'emballement thermique (T2) des accumulateurs du pack.

En ce qui concerne le phénomène d'emballement thermique, on se reportera à la publication [1] et au protocole décrit dans cette publication. Les températures dites « d'auto-échauffement » et « d'emballement thermique » sont respectivement notées T1 et T2 dans cette publication.

La température T1, typiquement 70°C, dans la figure 2 de la publication, est la température à partir de laquelle l'accumulateur s'échauffe sans source externe à une vitesse typique de 0,02 °C/min en conditions adiabatiques.

La température T2, typiquement 150°C, dans la figure 2 de la publication, est la température à partir de laquelle l'accumulateur s'échauffe à une vitesse d'échauffement typique de 10°C/min en conditions adiabatiques, ce qui conduit à la fusion du séparateur dans le faisceau électrochimique de l'accumulateur, à un court-circuit et donc à l'effondrement de la tension.

Par « emballement thermique », on peut ainsi comprendre ici et dans le cadre de l'invention, un rapport entre la valeur de la dérivée de la température d'échauffement et celle du temps au moins égal à 0,02°C par min.

On pourra se reporter aux publications [2] et [3] et plus particulier aux courbes de leur figure 1 respective qui montrent que les propriétés magnétiques de ferrites en sont modifiées en fonction de la température. Plus particulièrement, on voit clairement un effondrement des propriétés magnétiques au passage de la température de Curie.

En outre, ces publications [2] et [3] expliquent deux méthodes de fabrication distinctes pour obtenir des ferrites avec des températures de Curie qui peuvent être ajustées à la fabrication :
- dans la publication [2], le process de fabrication est modifié avec une même composition de ferrite, ce qui fait varier la température de Curie entre 130°C et 250°C. Il est également démontré qu'avec une composition différente de ferrite, que la température de Curie peut être vers 100-110°C ;
- dans la publication [3], les auteurs font varier la composition du matériau. Ils ont pu obtenir des ferrites avec des températures de Curie comprises entre 35 et 65°C. Avec des ajustements de composition, il est très probable de pouvoir pour arriver à des températures de Curie en dessous de 100°C, tout en restant suffisamment élevées pour ne pas être atteinte par l'environnement d'un accumulateur métal-ion.

A titre d'exemple, des températures de Curie qui seraient obtenues dans la gamme 80-150°C, par adaptation du process de fabrication et/ou de la composition des matériaux ferromagnétiques, seraient optimales vis-à-vis de la température d'emballement thermique des accumulateurs du pack, la partie inférieure de la gamme, soit entre 80 et 90°C, probablement optimale pour la minimisation des moyens pilotés par chauffage ou par injection de courant dans le cadre de l'invention.

L'aimant permanent peut être un aimant fritté ou un plasto-aimant. Un aimant permanent désigné usuellement sous l'appellation « plasto-aimant », est un matériau composite constitués d'un liant thermoplastique ou thermodurcissable et d'une poudre magnétique. La fabrication de ces plasto-aimants s'effectue par compression à froid (liant thermodurcissable) ou par injection sous pression (liant thermoplastique). L'aimantation peut être réalisée soit pendant le moulage (matériau anisotrope), soit après le moulage.

L'aimant fritté ou le plasto-aimant est avantageusement à base de terres rares de préférence en samarium-cobalt ou en néodyme-fer-bore, ou ferrite. L'aimant fritté peut également être en alliage aluminium-nickel-cobalt.

Selon un autre mode de réalisation avantageux, au moins une des deux bornes de sortie de chaque accumulateur comprenant au moins une deuxième pièce ferromagnétique agencée autour ou à l'intérieur de la pièce électriquement conductrice, la deuxième pièce ferromagnétique étant fermée par la plaque de fermeture dans la configuration de fermeture du circuit magnétique.

Selon ce mode, il peut être prévu au moins une troisième pièce ferromagnétique agencée autour de la deuxième pièce ferromagnétique en formant un logement annulaire dans lequel est logé un plasto-aimant, la bobine étant agencée à l'intérieur de la première pièce ferromagnétique.

De préférence, chaque pièce ferromagnétique est en fer doux.

De préférence, la lame flexible est en cuivre-béryllium.

Avantageusement, chaque pièce électriquement conductrice de chaque verrou est dans le même matériau qu'une borne de sortie d'accumulateur.

De préférence, chaque pièce électriquement conductrice de chaque verrou est en aluminium ou en cuivre.

Selon un premier mode de réalisation avantageux, le pack-batterie comprend au moins une rondelle ondulée ou éventail électriquement conductrice, agencée telle que, dans la configuration de fermeture des circuits magnétiques de connexion, elle assure un contact électrique entre la borne de sortie munie d'un verrou et l'un des busbars.

Selon un deuxième mode de réalisation avantageux, le pack-batterie comprend au moins une rondelle ondulée ou éventail électriquement conductrice, agencée telle que, dans la configuration de fermeture des circuits magnétiques de shunt, elle assure un contact électrique entre la lame et l'un des busbars.

De préférence, chaque rondelle est en alliage cuivre-phosphore.

Selon une première configuration, la première ou la deuxième borne de sortie est agencée sur une face du boitier ou de l'emballage souple, tandis que, respectivement, la deuxième ou la première borne de sortie est agencée sur une face opposée du boitier ou de l'emballage souple, l'accumulateur étant agencé horizontalement de sorte que sa chute par gravité selon ii/ a lieu perpendiculairement à son axe longitudinal.

Selon une deuxième configuration, les première et deuxième bornes de sortie étant toutes deux agencées sur la même face du boitier ou de l'emballage souple, l'accumulateur étant agencé verticalement de sorte que sa chute par gravité selon ii/ a lieu selon son axe longitudinal.

Avantageusement, chaque accumulateur comprend un BMS fixé sur le boitier ou l'emballage souple de l'accumulateur et alimenté électriquement par ce dernier.

Selon un mode de réalisation avantageux, le pack-batterie comprend une structure en nid d'abeille comprenant une pluralité de logements adaptés chacun pour guider un accumulateur chutant par gravité, chaque logement étant susceptible d'être rempli par un liquide caloporteur au moins une fois la chute de l'accumulateur réalisée, afin de refroidir ce dernier.

De préférence, le liquide caloporteur est celui d'un circuit de refroidissement du pack-batterie ou un liquide indépendant dudit circuit de refroidissement dont l'amenée dans chaque logement est pilotée par le BMS du pack-batterie ou un liquide résultant du changement d'état d'un matériau à changement de phase (MCP) obtenu par l'échauffement de l'accumulateur.

Chaque batterie ou accumulateur peut être de type Li-ion et comprendre:
- un matériau d'électrode(s) négative(s) est choisi dans le groupe comportant le graphite, le lithium, l'oxyde de titanate Li4TiO5O12 ;
- un matériau d'électrode(s) positive(s) est choisi dans le groupe comportant LiFePO4, LiCoO2, LiNi0.33Mn0.33Co0.33O2.

L'invention concerne également, sous l'un de ses aspects, et selon une première alternative, un pack-batterie comprenant :
- une pluralité de batteries ou d'accumulateurs électrochimiques reliés en série et/ou en parallèle électrique entre eux au moyen d'une pluralité de barres de connexion, électriquement conductrices, dites busbars ;
- un ou plusieurs systèmes électroniques de commande (BMS) adaptés chacun pour charger et contrôler les états d'au moins une partie de la pluralité d'accumulateurs ;
- au moins un moyen de commutation simple, destiné à réaliser des connexions/déconnexions électriques, à la demande d'un ou plusieurs accumulateurs du reste du pack, le moyen de commutation simple comprenant :
   - au moins une lame électriquement conductrice, flexible, fixée à l'une de ses extrémités à un point de fixation,
   - au moins une première pièce ferromagnétique formant une plaque de fermeture magnétique, insérée respectivement dans la lame flexible ou dans un des busbars,
   - au moins un élément formant un verrou magnétique, comprenant une pièce électriquement conductrice autour ou à l'intérieur de laquelle est logé un aimant permanent et un fil électriquement conducteur enroulé formant une bobine destinée à générer un champ magnétique parallèle au champ magnétique de l'aimant permanent; la cavité étant insérée en étant en contact électrique respectivement dans l'un des busbars ou dans la lame,

le moyen de commutation simple étant configuré de sorte que successivement:
i/ lorsque la bobine d'un verrou magnétique est alimentée électriquement par le pilotage d'un des BMS dans un sens donné, elle produit un champ magnétique qui conjugué avec celui de l'aimant permanent, génère une force d'attraction ou de répulsion supérieure à la force mécanique de la lame élastique, ce qui provoque le rapprochement ou l'écartement de la plaque de fermeture vis-à-vis de son aimant permanent, en réalisant ainsi une connexion ou déconnexion électrique d'un ou plusieurs accumulateurs;
ii/ lorsque la bobine du verrou magnétique n'est plus alimentée électriquement, la force magnétique de l'aimant permanent est supérieure à la force mécanique de la lame flexible, ce qui maintient le contact électrique ou l'écartement entre la lame et l'un des busbars et ainsi la connexion ou déconnexion électrique du ou des accumulateurs;
iii/ lorsque la bobine est alimentée électriquement par pilotage du BMS dans un sens opposé à celui donné, elle produit un champ magnétique opposé à celui de l'étape i/, jusqu'à obtenir une force d'attraction ou de répulsion inférieure à la force mécanique de la lame élastique, ce qui provoque l'écartement ou le rapprochement de la plaque de fermeture du verrou magnétique vis-à-vis de son aimant permanent et donc l'ouverture ou la fermeture du circuit magnétique et la suppression ou la réalisation du contact électrique entre la lame et l'un des busbars en réalisant ainsi une déconnexion ou reconnexion électrique du ou des accumulateurs au reste du pack.

L'invention concerne également selon une deuxième alternative, un pack-batterie comprenant:
- une pluralité de batteries ou d'accumulateurs électrochimiques (A1-An), reliés en série et/ou en parallèle électrique entre eux au moyen d'une pluralité de barres de connexion, électriquement conductrices, dites busbars ;
- un ou plusieurs systèmes électroniques de commande (BMS) adaptés chacun pour charger et contrôler les états d'au moins une partie de la pluralité d'accumulateurs ;
- au moins un moyen de commutation électrique, dit inverseur, destiné à réaliser des connexions/déconnexions électriques, à la demande, d'un ou plusieurs accumulateurs du reste du pack tout en assurant des continuités électriques au sein de l'ensemble du pack ou du reste du pack, l'inverseur comprenant :
   - au moins une lame électriquement conductrice, rigide, comprenant deux parties inclinées l'une par rapport à l'autre, la lame étant montée pivotante au niveau de sa jonction entre les deux parties ;
   - au moins deux premières pièces ferromagnétiques formant chacune une plaque de fermeture magnétique, insérée respectivement dans une partie de la lame rigide ou dans l'un des busbars;
   - au moins deux éléments formant chacun un verrou magnétique, comprenant chacun une pièce électriquement conductrice autour ou à l'intérieur de laquelle est logé un aimant permanent et un fil électriquement conducteur enroulé formant une bobine destinée à générer un champ magnétique parallèle au champ magnétique de l'aimant permanent; chaque pièce électriquement conductrice étant insérée en étant en contact électrique respectivement avec le busbar ou dans une partie de la lame rigide;
   - une tresse métallique reliant la lame rigide à un des busbars;
      l'inverseur étant configuré de sorte que:
      j/ lorsqu'aucune des deux bobines n'est initialement alimentée électriquement, le circuit magnétique d'un des deux verrous est en configuration initiale fermée par son aimant permanent qui exerce un couple d'attraction, défini comme étant le produit entre la force d'attraction et la longueur d'une des parties de la lame, supérieur à celui de l'autre aimant permanent qui laisse donc le circuit magnétique de l'autre des deux verrous en configuration initiale ouverte avec sa plaque de fermeture distante de son aimant permanent;
      jj/ lorsque la bobine du verrou initialement fermé est alimentée électriquement par le pilotage d'un des BMS dans un sens donné, elle produit un champ magnétique qui s'oppose à celui de son aimant permanent, ce qui provoque la diminution du couple de fermeture par ce dernier jusqu'à ce qu'il soit inférieur au couple d'attraction exercé par l'aimant permanent du verrou initialement ouvert, ce qui provoque le basculement par pivotement de la lame et ainsi la fermeture du circuit magnétique du verrou initialement ouvert et simultanément l'ouverture du circuit magnétique du verrou initialement fermé, en réalisant ainsi une déconnexion électrique d'un ou plusieurs accumulateurs tout en assurant une continuité électrique au sein du reste du pack;
      les étapes j/ et jj/ pouvant être réalisées réciproquement à partir du verrou fermé pour revenir à la configuration initiale en réalisant ainsi une reconnexion électrique du ou des accumulateurs au reste du pack avec un continuité électrique au sein de l'ensemble du pack.

L'invention concerne également, sous l'un de ses aspects, et selon une première alternative, un dispositif de connexion/déconnexion entre un accumulateur et une barre de connexion électrique, dite busbar, comprenant :
- une borne de sortie de l'accumulateur métal-ion comprenant :
   - une pièce électriquement conductrice,
   - un verrou magnétique comprenant un aimant permanent,
- une première pièce ferromagnétique solidaire du busbar, formant une plaque de fermeture d'un circuit magnétique avec le verrou magnétique, le circuit magnétique fermé assurant une connexion mécanique et électrique entre la borne de sortie et le busbar.

Selon une deuxième alternative, l'invention concerne un dispositif de connexion/déconnexion entre un accumulateur et une barre de connexion électrique, dite busbar, comprenant :
- un busbar comprenant :
   - une pièce électriquement conductrice,
   - un verrou magnétique comprenant un aimant permanent,
- une borne de sortie de l'accumulateur comprenant une première pièce ferromagnétique, formant une plaque de fermeture d'un circuit magnétique avec le verrou magnétique, le circuit magnétique fermé assurant une connexion mécanique et électrique entre la borne de sortie et le busbar.

L'invention concerne également, sous l'un de ses aspects, et selon une première alternative, un dispositif de connexion/déconnexion entre un accumulateur et une barre de connexion électrique, dite busbar, comprenant :
- un adaptateur d'interface comprenant :
   - un corps comprenant au moins un logement traversant d'une borne de sortie de l'accumulateur et intégrant en son sein au moins un verrou magnétique comprenant un aimant permanent,
   - au moins une pièce électriquement conductrice adaptée pour être fixée avec contact électrique à une borne de sortie de l'accumulateur,
- au moins une première pièce ferromagnétique, solidaire du busbar, formant une plaque de fermeture d'un circuit magnétique avec le verrou magnétique, le circuit magnétique fermé assurant une connexion mécanique et électrique entre la borne de sortie et le busbar.

Selon une deuxième alternative, l'invention concerne un dispositif de connexion/déconnexion entre un accumulateur et une barre de connexion électrique, dite busbar, comprenant :
- un adaptateur d'interface comprenant :
   - un corps comprenant au moins un logement traversant pour loger une borne de sortie de l'accumulateur et intégrant en son sein au moins une première pièce ferromagnétique, solidaire du busbar, formant une plaque de fermeture d'un circuit magnétique ,
   - au moins une pièce électriquement conductrice adaptée pour être fixée avec contact électrique à une borne de sortie de l'accumulateur,
- au moins un verrou magnétique comprenant un aimant permanent, solidaire du busbar, le circuit magnétique entre verrou et plaque de fermeture fermé assurant une connexion mécanique et électrique entre la pièce électriquement conductrice et le busbar.

L'invention concerne également, sous l'un de ses aspects, et selon une première alternative, un dispositif de connexion/déconnexion entre un accumulateur et des barres de connexion électrique, dites busbars, et de shunt de l'accumulateur, comprenant :
- une batterie ou accumulateur comprenant :
   - un boitier ou un emballage souple,
   - au moins une borne de sortie comprenant:
   - une pièce électriquement conductrice,
   - un verrou magnétique comprenant un aimant permanent et un fil électriquement conducteur enroulé formant une bobine ;
- un système électronique de commande (BMS) adapté pour charger et contrôler les états de l'accumulateur;
- au moins une pièce ferromagnétique solidaire d'une première barre de connexion électrique, dite busbar, formant une plaque de fermeture d'un circuit magnétique avec le verrou magnétique de la borne de sortie ;
- au moins une lame électriquement conductrice, flexible, fixée à un point de fixation sur l'un des busbars, comprenant un aimant permanent ;
   le dispositif étant configuré de sorte que :
   i/ lorsque les bobines ne sont pas alimentées électriquement, la force magnétique d'attraction des aimants permanents de la borne de sortie sur la plaque de fermeture, dans la configuration des circuits magnétiques fermés, assure la connexion mécanique et électrique de la borne de sortie au premier busbar; et l'aimant permanent de la lame flexible est répulsé par celui de la borne de sortie tel que la lame flexible ne peut pas être en contact électrique avec le premier busbar,
   ii/ lorsque sur pilotage du BMS, la bobine de la borne de sortie est alimentée électriquement dans un sens tel qu'elle génèreune force magnétique opposée à la force magnétique d'attraction de l' aimant permanent de la borne de sortie jusqu'à assurer la déconnexion mécanique entre cette borne de sortie et le premier busbar, ce qui provoque une chute par gravité de l'accumulateur et simultanément, du fait de l'absence de répulsion magnétique, la fermeture du circuit magnétique entre l'aimant permanent de la lame flexible et la plaque de fermeture du premier busbar et la connexion électrique entre le premier et un autre busbar par le biais respectivement cette lame flexible, et par-là le shunt de l'accumulateur.

Selon une deuxième alternative, l'invention concerne un dispositif de connexion/déconnexion entre un accumulateur et des barres de connexion électrique, dites busbars, et de shunt de l'accumulateur en cas de défaillance de dernier comprenant :
- une batterie ou accumulateur comprenant :
   - un boitier ou un emballage souple,
   - au moins une borne de sortie comprenant:
   - une pièce électriquement conductrice,
   - un verrou magnétique comprenant un aimant permanent et une résistance électrique chauffante;
- un système électronique de commande (BMS) adapté pour charger et contrôler les états de l'accumulateur;
- au moins une pièce ferromagnétique solidaire d'une première barre de connexion électrique, dite busbar, formant une plaque de fermeture d'un circuit magnétique avec le verrou magnétique de la borne de sortie ;
- au moins une lame électriquement conductrice, flexible, fixée à un point de fixation sur l'un des busbars, comprenant un aimant permanent ;
   le dispositif étant configuré de sorte que :
   i/ lorsque la résistance chauffante n'est pas alimentée électriquement, la force magnétique d'attraction de l'aimant permanent de la borne de sortie sur la plaque de fermeture, dans la configuration des circuits magnétiques fermés, assure la connexion mécanique et électrique de la borne de sortie au premier busbar; et l'aimant permanent de la lame flexible est répulsé par celui de la borne de sortie tel que la lame flexible ne peut pas être en contact électrique avec le premier busbar,
   ii/ lorsque sur pilotage du BMS, la résistance chauffante de la borne de sortie est alimentée électriquement, l'aimant permanent de la borne de sortie chauffe au moins jusqu'à une température à partir de laquelle il perd ses propriétés magnétiques, jusqu'à la déconnexion mécanique entre la borne de sortie et le premier busbar, ce qui provoque une chute par gravité de l'accumulateur et simultanément, du fait de l'absence de répulsion magnétique, la fermeture du circuit magnétique entre l'aimant permanent de la lame flexible et la plaque de fermeture du premier busbar et la connexion électrique entre le premier et un autre busbar par le biais de la lame flexible, et par-là le shunt de l'accumulateur.

L'invention concerne également, sous l'un de ses aspects, un procédé d'assemblage d'un pack-batterie et à des busbars, comprenant les étapes suivantes :
a/ mise à disposition d'une pluralité d'accumulateurs comprenant chacun:
   - un boitier ou un emballage souple,
   - une première borne de sortie et une deuxième borne de sortie de polarité opposée à la première borne de sortie, au moins une des deux bornes de sortie comprenant:
   - une pièce électriquement conductrice,
   - un verrou magnétique comprenant un aimant permanent et un fil électriquement conducteur enroulé formant une bobine destinée à générer un champ magnétique parallèle au champ magnétique de l'aimant permanent ;
b/ mise à disposition d'un substrat isolant électriquement comprenant une première et une deuxième barre de connexion, électriquement conductrices, dites busbars, sur au moins une desquelles sont fixées une pièce ferromagnétique, formant une plaque de fermeture d'un circuit magnétique avec le verrou magnétique de la borne de sortie;
c/ mise à disposition d'une structure en nid d'abeille comprenant une pluralité de logements adaptés chacun pour recevoir un accumulateur ;
d/ fixation de la structure en nid d'abeille sur le substrat isolant ;
e/ insertion de chaque accumulateur dans un des logements de la structure en nid d'abeille de sorte que chaque accumulateur est en lévitation magnétique en regard du substrat isolant du fait de la répulsion magnétique de son aimant permanent par au moins un autre aimant permanent ;
f/ variation du champ magnétique de l'autre aimant permanent en le déplaçant ou en activant une bobine en regard de l' aimant permanent de l'accumulateur afin qu'il exerce sa force d'attraction sur chaque plaque de fermeture et, ainsi permettre la fixation avec verrouillage magnétique de la borne de sortie de chaque accumulateur avec le busbar

L'invention concerne également, sous l'un de ses aspects, et selon une première alternative, un dispositif de soufflage d'arc électrique entre une borne de sortie d'accumulateur et une barre de connexion électrique, dite busbar, comprenant:
- une borne de sortie de l'accumulateur comprenant :
   - une pièce électriquement conductrice,
   - un verrou magnétique comprenant un aimant permanent,
   - une rondelle ondulée ou éventail électriquement conductrice, assurant un contact électrique entre la borne de sortie et le busbar,
   - une pièce à bas point de fusion, de préférence inférieure à 250°C, agencée à l'intérieur de la rondelle;
- une première pièce ferromagnétique solidaire du busbar, formant une plaque de fermeture d'un circuit magnétique avec le verrou magnétique, le circuit magnétique fermé assurant une connexion mécanique entre la borne de sortie et le busbar tout en permettant le contact électrique entre eux;
le dispositif étant configuré de sorte que lorsque des arcs électriques ont lieu entre la borne de sortie et le busbar, la chaleur dégagée par les arcs vaporise la pièce à bas point de fusion, ce qui génère un gaz sous pression qui allonge les arcs vers l'extérieur de la pièce à bas point de fusion et ainsi les refroidit dans le milieu ambiant jusqu'à leur extinction par soufflage.

Selon une deuxième alternative, l'invention concerne un dispositif de soufflage d'arc électrique entre une borne de sortie d'accumulateur et une barre de connexion électrique, dite busbar, comprenant:
- un busbar comprenant :
   - une pièce électriquement conductrice,
   - un verrou magnétique comprenant un aimant permanent,
   - une rondelle ondulée ou éventail électriquement conductrice, assurant un contact électrique entre la borne de sortie et le busbar,
   - une pièce à bas point de fusion, de préférence inférieure à 250°C, agencée à l'intérieur de la rondelle;
- une borne de sortie de l'accumulateur comprenant une première pièce ferromagnétique, formant une plaque de fermeture d'un circuit magnétique avec le verrou magnétique, le circuit magnétique fermé assurant une connexion mécanique entre la borne de sortie et le busbar tout en permettant le contact électrique entre eux;
le dispositif étant configuré de sorte que lorsque des arcs électriques ont lieu entre la borne de sortie et le busbar, la chaleur dégagée par les arcs vaporise la pièce à bas point de fusion, ce qui génère un gaz sous pression qui allonge les arcs vers l'extérieur de la pièce à bas point de fusion et ainsi les refroidit dans le milieu ambiant jusqu'à leur extinction par soufflage.

L'invention concerne également, sous l'un de ses aspects, et selon une première alternative, un dispositif d'extinction d'arc électrique entre une borne de sortie d'accumulateur et une barre de connexion électrique, dite busbar, comprenant:
- une borne de sortie de l'accumulateur comprenant :
   - une pièce électriquement conductrice,
   - un verrou magnétique comprenant un aimant permanent,
- une première pièce ferromagnétique solidaire du busbar, formant une plaque de fermeture d'un circuit magnétique avec le verrou magnétique, le circuit magnétique fermé assurant une connexion mécanique et électrique entre la borne de sortie et le busbar,
- une rondelle ondulée ou éventail électriquement conductrice, présentant des saillies, la rondelle assurant un contact électrique entre la borne de sortie et le busbar ;
le dispositif étant configuré de sorte que lorsque des arcs électriques ont lieu entre la borne de sortie et le busbar, les saillies de la rondelle rapprochent les arcs de la plaque de fermeture qui absorbe la chaleur dégagée et ainsi les refroidissent jusqu'à leur extinction.

Selon une deuxième alternative, l'invention concerne un dispositif d'extinction d'arc électrique entre une borne de sortie d'accumulateur et une barre de connexion électrique, dite busbar, comprenant:
- un busbar comprenant :
   - une pièce électriquement conductrice,
   - un verrou magnétique comprenant un aimant permanent,
- une borne de sortie de l'accumulateur comprenant une première pièce ferromagnétique solidaire du busbar, formant une plaque de fermeture d'un circuit magnétique avec le verrou magnétique, le circuit magnétique fermé assurant une connexion mécanique et électrique entre la borne de sortie et le busbar,
- une rondelle ondulée ou éventail électriquement conductrice, présentant des saillies, la rondelle assurant un contact électrique entre la borne de sortie et le busbar ;
le dispositif étant configuré de sorte que lorsque des arcs électriques ont lieu entre la borne de sortie et le busbar, les saillies de la rondelle rapprochent les arcs de la plaque de fermeture qui absorbe la chaleur dégagée et ainsi les refroidissent jusqu'à leur extinction.

L'invention concerne enfin, sous l'un de ses aspects, et selon une première alternative, un dispositif de connexion/déconnexion entre une borne de sortie d'un accumulateur et une barre de connexion électrique, dite busbar, comprenant :
- un adaptateur d'interface comprenant une enveloppe comprenant une ouverture , adaptée pour venir se fixer à une borne de sortie de l'accumulateur, et un verrou magnétique comprenant un aimant permanent,
- au moins une première pièce ferromagnétique, solidaire du busbar, formant une plaque de fermeture d'un circuit magnétique avec le verrou magnétique, le circuit magnétique fermé assurant une connexion mécanique et électrique entre la borne de sortie et le busbar.

Selon une deuxième alternative, l'invention concerne un dispositif de connexion/déconnexion entre une borne de sortie d'un accumulateur et une barre de connexion électrique, dite busbar, comprenant :
- un adaptateur d'interface comprenant une enveloppe comprenant une ouverture, adaptée pour venir se fixer à une borne de sortie de l'accumulateur, et au moins une première pièce ferromagnétique,
- au moins un verrou magnétique comprenant un aimant permanent, solidaire du busbar, le circuit magnétique fermé assurant une connexion mécanique et électrique entre la borne de sortie et le busbar.

### Description détaillée

D'autres avantages et caractéristiques de l'invention ressortiront mieux à la lecture de la description détaillée d'exemples de mise en œuvre de l'invention faite à titre illustratif et non limitatif en référence aux figures suivantes parmi lesquelles :
- la figure 1 est une vue schématique en perspective éclatée montrant les différents éléments d'un accumulateur lithium-ion,
- la figure 2 est une vue de face montrant un accumulateur lithium-ion avec son emballage souple selon l'état de l'art,
- la figure 3 est une vue en perspective d'un accumulateur lithium-ion selon l'état de l'art avec son emballage rigide constitué d'un boitier de forme cylindrique;
- la figure 4 est une vue en en perspective d'un accumulateur lithium-ion selon l'état de l'art avec son emballage rigide constitué d'un boitier de forme prismatique;
- la figure 5 est une vue en perspective d'un assemblage au moyen de busbars d'accumulateurs lithium-ion selon l'état de l'art, formant un pack-batterie ;
- les figures 6A et 6B sont des vues en coupe longitudinale illustrant respectivement la déconnexion et la connexion magnétique d'un dispositif selon l'invention, destiné à assurer la connexion/déconnexion mécanique et électrique entre une borne de sortie d'un accumulateur à faible courant, typiquement inférieur à 1A et un busbar ;
- les figures 7A et 7B sont des vues en coupe longitudinale illustrant respectivement la déconnexion et la connexion magnétique d'un dispositif selon l'invention, destiné à assurer la connexion/déconnexion mécanique et électrique entre une borne de sortie d'un accumulateur à courant élevé, typiquement supérieur à 1A et un busbar ;
- les figures 8 et 8A sont respectivement des vues de face et de côté d'une rondelle ondulée électriquement conductrice assurant le contact électrique entre busbar et pièce électriquement conductrice soit de la borne de sortie soit reliée à celle-ci, dans un dispositif selon les figures 7A et 7B;
- la figure 9 est une vue schématique en coupe longitudinale d'une variante du dispositif selon les figures 7A et 7B;
- la figure 10 est une vue schématique en coupe longitudinale d'un mode de réalisation avantageux du dispositif selon les figures 7A et 7B, selon lequel un pilotage de la connexion/déconnexion entre pièces magnétiques par bobine est possible;
- la figure 11 est une vue schématique en coupe longitudinale d'une variante du mode de réalisation avantageux du dispositif selon la figure 10;
- la figure 12 est une vue schématique en coupe longitudinale d'un mode de réalisation avantageux du dispositif qui est une représentation concrète du mode des figures 7A et 7B ;
- la figure 13 est une vue schématique en coupe longitudinale d'un mode de réalisation avantageux du dispositif qui est une alternative à celui de la figure 10 ;
- la figure 14 est une variante de la figure 12 ;
- la figure 15 est une variante de la figure 13 ;
- la figure 16 est une vue schématique en coupe longitudinale d'un mode de réalisation avantageux d'un dispositif à courant de puissance, avec intégration d'une partie de ce dernier dans une traversée formant borne de sortie d'un accumulateur métal-ion ;
- la figure 17 est une vue schématique en perspective de la pièce mâle avec son capot d'obturation d'une traversée selon la figure 16 ;
- la figure 18 est une vue schématique en perspective d'une variante de réalisation d'une pièce mâle d'une traversée selon l'invention ;
- la figure 19 est une vue schématique en perspective d'un accumulateur métal-ion de format prismatique intégrant deux bornes de sortie à verrou magnétique conformes à l'invention sur le couvercle du boitier d'accumulateur;
- la figure 20 est une vue schématique en perspective d'un accumulateur métal-ion de format cylindrique intégrant deux bornes de sortie à verrou magnétique conformes à l'invention l'une sur le couvercle du boitier d'accumulateur, l'autre sur le fond;
- la figure 21 est une vue schématique de côté et partiellement en coupe d'un accumulateur métal-ion selon la figure 20, avec les pièces ferromagnétiques insérées dans des busbars formant des plaques de fermeture du circuit avec les verrous magnétiques intégrés dans les bornes de sortie de l'accumulateur ;
- la figure 22 est une vue schématique en perspective et en éclaté partiel d'un accumulateur métal-ion existant de format prismatique avec un adaptateur d'interface intégrant des verrous magnétiques conformes à l'invention ;
- la figure 23 est une vue schématique en perspective de l'accumulateur avec son adaptateur d'interface selon la figure 22, dans sa configuration installée sur le boitier de l'accumulateur ;
- la figure 24 est une vue schématique en coupe longitudinale partielle d'un accumulateur et son adaptateur d'interface selon les figures 22 et 23 en regard de pièces ferromagnétiques insérées dans des busbars formant des plaques de fermeture du circuit avec les verrous magnétiques intégrés dans l'adaptateur ;
- la figure 25 est une vue schématique en perspective et en éclaté d'un autre adaptateur d'interface intégrant un verrou magnétique conforme à l'invention :
- la figure 26 est une vue schématique en perspective et en éclaté partiel d'un accumulateur métal-ion existant de format prismatique avec un adaptateur d'interface selon la figure 25 à fixer, emmancher ou à visser autour d'une borne de sortie de l'accumulateur ;
- la figure 27 est une vue schématique en coupe longitudinale partielle d'une borne de sortie d'un accumulateur autour de laquelle est emmanché un adaptateur d'interface en regard d'une pièce ferromagnétique insérées dans un busbar formant une plaque de fermeture du circuit avec le verrou magnétique intégré dans l'adaptateur ;
- les figures 28A et 28B reprennent le dispositif de la figure 10 et illustrent les étapes d'un premier mode de soufflage des arcs électriques susceptibles de se produire lors la déconnexion magnétique ;
- les figures 29A et 29B reprennent respectivement en vue de dessous les figures 28A et 28B et illustrent les emplacements des points de création des arcs électriques et leur convergence lors de l'extinction ;
- les figures 30 et 31 sont des vues schématiques en perspective respectivement en éclaté et assemblé d'une variante avantageuse de plaque de fermeture et contacts électriques réalisant l'extinction des arcs selon le premier mode;
- la figure 32 illustre en vue schématique de côté et de dessus la formation des arcs électriques avec une plaque de fermeture et contacts selon les figures 30 et 31;
- les figures 33A et 33B reprennent le dispositif de la figure 10 et illustrent les étapes d'un deuxième mode d'extinction des arcs électriques susceptibles de se produire lors la déconnexion magnétique ;
- la figure 34 est une vue schématique en coupe longitudinale d'un dispositif à shunt magnétique à lame flexible conforme à l'invention, destiné à assurer le shunt entre deux busbars ; la lame étant fixée avec connexion électrique à l'un des busbars ;
- la figure 35 est une vue schématique en coupe longitudinale d'un mode de réalisation avantageux du dispositif selon la figure 34, selon lequel le shunt est dupliqué, mais avec une fixation de chaque lame flexible réalisée sur une partie isolante;
- la figure 36 est une vue schématique en coupe longitudinale d'une variante du dispositif de shunt magnétique selon la figure 35;
- la figure 37 est un schéma électrique illustrant un dispositif à shunt magnétique conforme à l'invention, à fonction inverseur afin de shunter un circuit électrique comprenant un accumulateur métal-ion ;
- la figure 38 est une vue schématique en coupe longitudinale d'un dispositif à shunt magnétique à lame rigide conforme à l'invention, destiné à réaliser un inverseur entre deux busbars comme selon la figure 37 ;
- les figures 39A à 39E sont des vues schématiques en coupe longitudinale montrant les différentes étapes de fonctionnement d'un dispositif à la fois de connexion/déconnexion magnétique entre les deux bornes de sorties d'un accumulateur et deux busbars et de shunt magnétique de l'accumulateur défaillant déconnecté ;
- les figures 40 et 41 sont des vues en perspective d'un dispositif de connexion/déconnexion et de shunt magnétique selon les figures 39A à 39E, au sein d'un pack-batterie;
- les figures 42A et 42B sont des vues schématiques en coupe longitudinale montrant les différentes étapes de fonctionnement d'une variante d'un dispositif à la fois de connexion/déconnexion magnétique entre les deux bornes de sortie d'un accumulateur et deux busbars, intégrant une détection passive de la déconnexion magnétique par interrupteur reed;
- la figure 43 est une vue schématique en coupe longitudinale d'un dispositif à la fois de connexion/déconnexion magnétique entre un accumulateur et deux busbars et de shunt magnétique de l'accumulateur défaillant déconnecté, le dispositif consistant en un inverseur et fonctionnant par déconnexion d'une seule des deux bornes de sortie l'accumulateur ;
- les figures 44 à 46 illustrent en vue schématique en perspective les composants à différents stades de leur assemblage d'un pack-batterie à plusieurs branches en série d'accumulateurs en parallèle au sein de chaque branche, chaque accumulateur étant connecté à deux busbars au moyen d'un dispositif de connexion/déconnexion magnétique conforme à l'invention ;
- les figures 47 et 48 illustrent en vue en perspective un pack-batterie assemblé comme selon les figures 44 à 46 et qui intègrent en outre un dispositif de shunt magnétique entre deux busbars ;
- les figures 49 et 50 illustrent en vue en perspective un pack-batterie assemblé comme selon les figures 44 à 45 et qui intègrent en outre un inverseur entre deux busbars;
- les figures 51 à 53 illustrent en vue schématique en perspective les composants à différents stades de leur assemblage d'un pack-batterie à plusieurs branches en série d'accumulateurs en parallèle au sein de chaque branche, chaque accumulateur étant connecté à deux busbars au moyen d'un dispositif de connexion/déconnexion magnétique conforme à l'invention et le pack-batterie intègre au niveau de chaque branche un dispositif de shunt magnétique entre deux busbars;
- la figure 54 est une vue en perspective d'un dispositif de de shunt magnétique selon la figure 36, au sein du pack-batterie de la figure 53;
- les figures 55 à 57 illustrent en vue schématique en perspective les composants à différents stades de leur assemblage d'un pack-batterie à plusieurs branches en parallèle d'accumulateurs en série au sein de chaque branche, chaque accumulateur étant connecté à deux busbars au moyen d'un dispositif de connexion/déconnexion magnétique et de shunt magnétique conforme à l'invention, tel qu'illustré aux figures 39A à 39E;
- la figure 58 est une vue schématique en perspective d'une structure en nid d'abeille à logements individuels d'accumulateurs métal-ion unitaires d'un même pack-batterie ;
- la figure 59 est une vue schématique en éclaté d'un pack-batterie intégrant une structure en nid d'abeille selon la figure 56 et un substrat isolant électriquement intégrant des busbars connectés magnétiquement aux accumulateurs.

Les figures 1 à 5 sont relatives à des exemples différents d'accumulateur Li-ion, de boitiers et traversées formant des bornes ainsi qu'un pack-batterie assemblés par des busbars selon l'état de l'art. Ces figures 1 à 5 ont déjà été commentées en préambule et ne le sont donc pas plus ci-après.

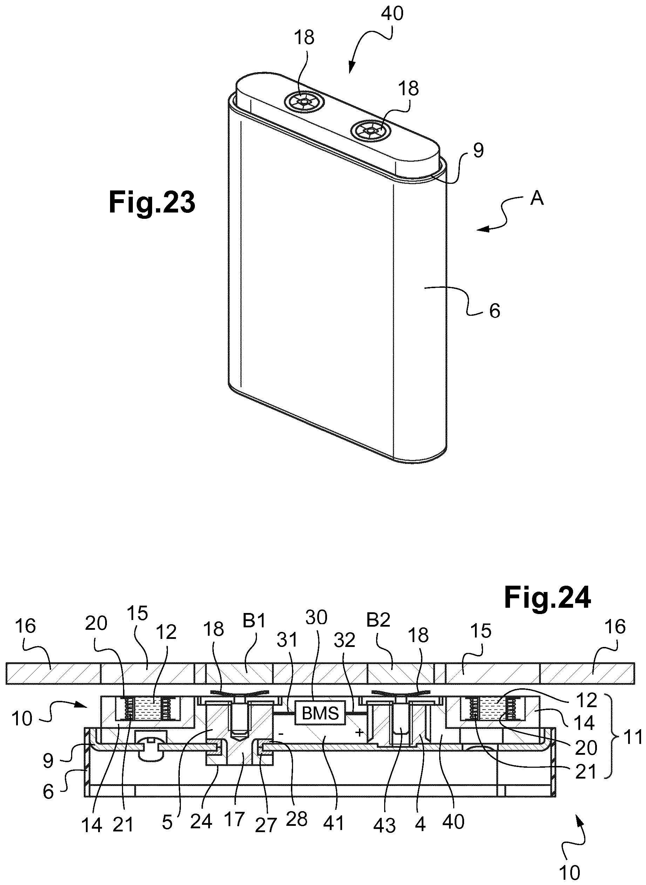

Par souci de clarté, les mêmes références désignant les mêmes éléments selon l'état de l'art et selon l'invention sont utilisées pour toutes les figures 1 à 59.

Dans l'ensemble de la présente demande, les termes « inférieur », « supérieur », « bas », « haut », « dessous » et « dessus » sont à comprendre par référence par rapport à un boitier d'accumulateur Li-ion positionné à la verticale avec son couvercle sur le dessus et une traversée formant borne de sortie faisant saillie à l'extérieur du boitier vers le haut.

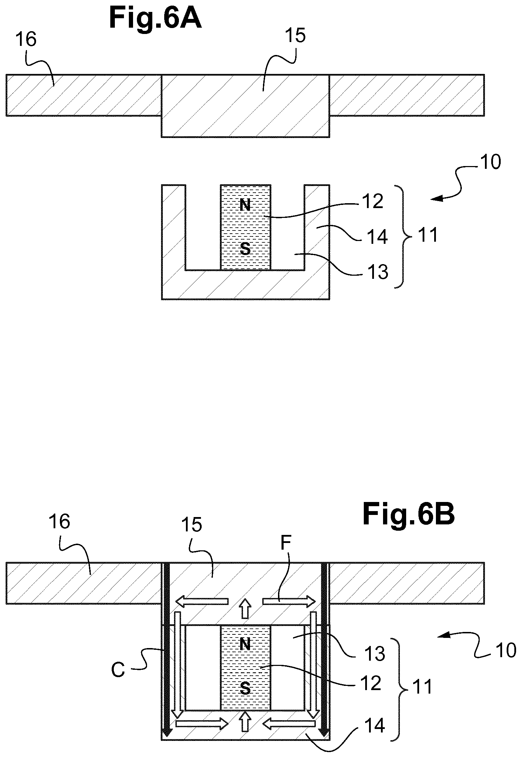

On a représenté en figures 6A et 6B un exemple de dispositif de connexion/déconnexion magnétique 10 selon l'invention, destiné à assurer la connexion/déconnexion mécanique et électrique entre une borne de sortie d'un accumulateur métal-ion à faible courant et un busbar.

Le dispositif 10 comprend ici un verrou magnétique 11 comprenant un aimant permanent 12, par exemple en néodyme cobalt, logé à l'intérieur d'une cavité 13 formée dans une pièce ferromagnétique 14, par exemple en fer doux. Cette pièce ferromagnétique est reliée électriquement à la borne de sortie non représentée ici.

Une autre pièce ferromagnétique 15, également en fer doux, est insérée dans un substrat isolant 16 intégrant un busbar non représenté ici, et en contact avec sa partie électriquement conductrice. Cette autre plaque 15 forme une plaque de fermeture d'un circuit magnétique avec le verrou magnétique 11.

Le circuit magnétique fermé est illustré en figure 6B : le passage du courant C se fait au travers des pièces ferromagnétiques 14, 15 et le flux magnétique F généré par l'aimant permanent 12 circule en boucle fermée à la fois dans l'aimant 12 et dans les pièces ferromagnétiques 14, 15.

Ainsi, en configuration fermée, la plaque de fermeture 15 vient refermer la pièce ferromagnétique 14 pour permettre une bonne circulation du flux magnétique F généré par l'aimant. Ce circuit magnétique présente une bonne perméabilité magnétique et sa fermeture permet un effort important entre les deux sous-ensembles, et donc garantit une connexion mécanique entre la borne de sortie et le busbar tout en permettant le contact électrique entre eux.

Dans l'exemple illustré, la plaque de fermeture 15 est une plaque pleine. On peut tout aussi bien envisager une plaque de fermeture sous la forme d'une rondelle ferromagnétique qui donc bien qu'évidée intérieurement vient fermer un circuit magnétique avec la pièce ferromagnétique 14.

Le courant électrique de puissance n'étant pas très intense, il peut passer à travers le matériau ferromagnétique des pièces 14, 15 qui assure dans cette configuration la conduction électrique et le contact électrique entre les deux sous-ensembles du dispositif. Ici, la plaque de fermeture 15 doit être en contact électrique direct avec la pièce ferromagnétique inférieure 14 pour permettre une conduction électrique du courant de puissance.

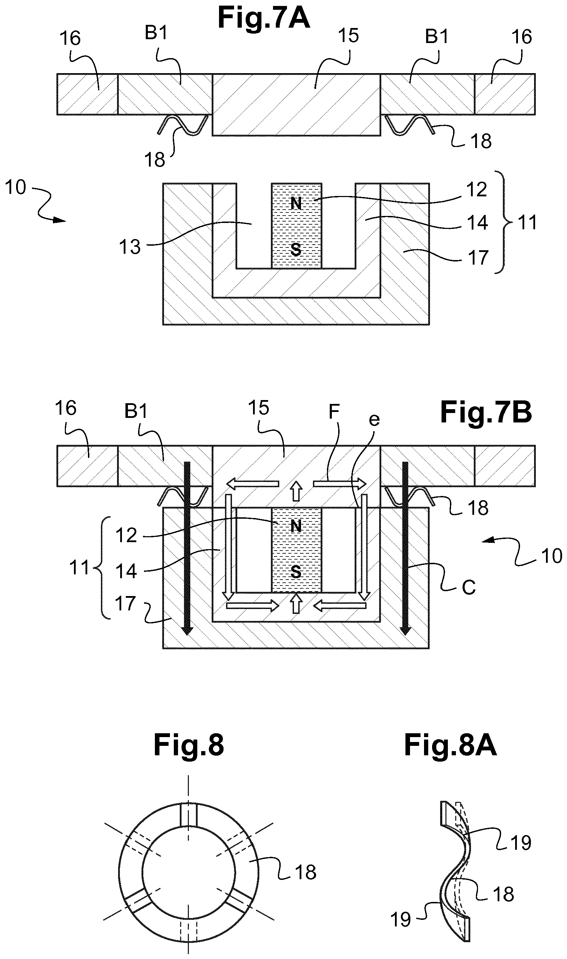

Les figures 7A et 7B illustrent un dispositif de connexion/déconnexion magnétique pour des courants de puissance élevés, typiquement supérieurs à 1A. Dans ce cas, les pièces de conduction électrique qui assurent le passage du courant de puissance et la qualité du contact électrique deviennent des paramètres importants.

Des pièces électriquement conductrices sont donc ajoutées. Tout d'abord, la pièce ferromagnétique du haut 15 est directement insérée dans le busbar électriquement conducteur B1. La pièce ferromagnétique 15, typiquement en fer doux peut être insérée par emmanchement en force ou vissage ou rivetage au busbar B1, typiquement en cuivre.

Ensuite, la pièce ferromagnétique du bas 14 est fixée typiquement par emmanchement dans la cavité d'une pièce électriquement conductrice 17. Ces deux pièces électriquement conductrices B1, 17 sont des conducteurs électriques de bonne qualité, typiquement en cuivre ou aluminium. La résistivité de ces conducteurs étant très inférieure à celui des matériaux ferromagnétiques des pièces 14, 15, notamment le fer doux, la majeure partie du courant de puissance va passer à travers ces conducteurs B1, 17.

Sur la figure 7B, le circuit magnétique est fermé : la circulation du courant de puissance C passe à travers les pièces conductrices B1, 17. Le flux magnétique F de l'aimant permanent est refermé par le circuit magnétique pour maximiser les efforts magnétiques.

Sur cette figure 7B est montrée la présence d'un léger entrefer e entre pièces ferromagnétiques 14, 15, qui certes diminue très légèrement la force de connexion mais permet avantageusement de laisser un jeu fonctionnel entre ces pièces.

En outre, une rondelle éventail ou ondulée 18, électriquement conductrice, est agencée autour de la pièce ferromagnétique 15 du haut. Dans l'exemple illustré, la pièce ferromagnétique 15 est en saillie par rapport au busbar B1 et la rondelle éventail 18 est agencée autour de la partie en saillie de la pièce 15. De préférence, cette rondelle 18 est en alliage cuivre-phosphore.

Cette rondelle 18 permet de garantir un bon contact électrique En effet, un bon contact électrique nécessite une surface de contact importante et un effort pour compenser les irrégularités des surfaces. La rondelle éventail 18 permet d'établir plusieurs points de contact bien définis en concentrant l'effort et en compensant les jeux mécaniques.

Les saillies 19 de la rondelle 18 permettent d'établir plusieurs points de contact parallèles entre eux, ce qui réduit la résistance électrique globale entre les pièces conductrices B1, 17.

Un exemple de forme avantageuse de rondelle éventail conforme à l'invention 18 est montré aux figures 8 et 8A.

Des exemples de dimensionnement de rondelles éventails 18 selon les figures 8 et 8A sont indiqués dans le tableau ci-dessous. Les rondelles sont présentées ici circulaires mais d'autres formes peuvent être envisagées, typiquement carrée ou rectangulaire, selon la forme de la borne.

| V (mm) | | D (mm) | | t (mm) | h (mm) | Charge (valeur de référence | | | | | |
|---|---|---|---|---|---|---|---|---|---|---|---|
| | | | | | | Déformation | Hauteur comprimée | Charge | Déformation | Hauteur comprimée | Charge |
| Diamètre intérieur | Tolérance | Diamètre extérieur | Tolérance | Epaisseur | Position libre | F (mm) | h-F | (N) | F (mm) | h-F | (N) |
| 3 | +0,2 | 3,6 | 0 | | 0,5 | 0,1 | 0,4 | 0,35 | 0,3 | 0,2 | 0,77 |
| | 0 | 4,2 | -0,2 | | | | | 0,73 | | | 1,96 |
| 4 | | 5 | | | | | | 0,47 | | | 0,91 |
| | | 6 | | 0,05 | 0,7 | 0,2 | 0,5 | 0,87 | 0,4 | 0,3 | 1,62 |
| 5 | | 7 | | | | | | 0,60 | | | 1,11 |
| | | 8 | | | | | | 0,69 | | | 1,25 |
| | | 10 | | | | | | 0,75 | | | 1,42 |
| | | | | | | | | | | | |
| | | 10 | | | | | | 5,23 | | | 15,33 |
| | | 12 | | | | | | 5,10 | | | 19,00 |
| 8 | | 10 | | | | | | 1,88 | | | 4,93 |
| | +0,3 | 12 | 0 | | | | | 2,93 | | | 8,72 |
| | 0 | 16 | -0,3 | | | | | 2,84 | | | 11,00 |
| 10 | | 12 | | | | | | 1,03 | | | 2,71 |
| | | 14 | | | | | | 1,31 | | | 4,46 |
| | | 16 | | | | | | 1,76 | | | 5,82 |
| 12 | | 14 | | | | | | 0,69 | | | 1,71 |
| | | 15 | | | | | | 0,98 | | | 2,58 |
| | | 17 | | | | | | 1,20 | | | 3,58 |
| 16 | | 18 | | 0,15 | 1,5 | 0,5 | 1,0 | 1,33 | 1,0 | 0,5 | 2,82 |
| | | 20 | | | | | | 2,56 | | | 5,95 |
| | | 28 | | | | | | 4,28 | | | 12,61 |
| 20 | +0,5 | 24 | 0 | | | | | 1,43 | | | 3,31 |
| | 0 | 28 | -0,5 | | | | | 2,34 | | | 5,94 |
| 22 | | 28 | | | | | | 1,48 | | | 3,76 |
| | | 30 | | | | | | 1,74 | | | 4,59 |
| 25 | +0,9 | 30 | +0,9 | | | | | 5,40 | | | 8,78 |
| | 0 | 35 | 0 | 0,2 | 3,0 | 1,0 | 2,0 | 8,20 | 2,0 | 1,0 | 16,25 |
| 30 | | 35 | | | | | | 2,92 | | | 5,77 |
| | | 38 | | | | | | 4,30 | | | 9,29 |

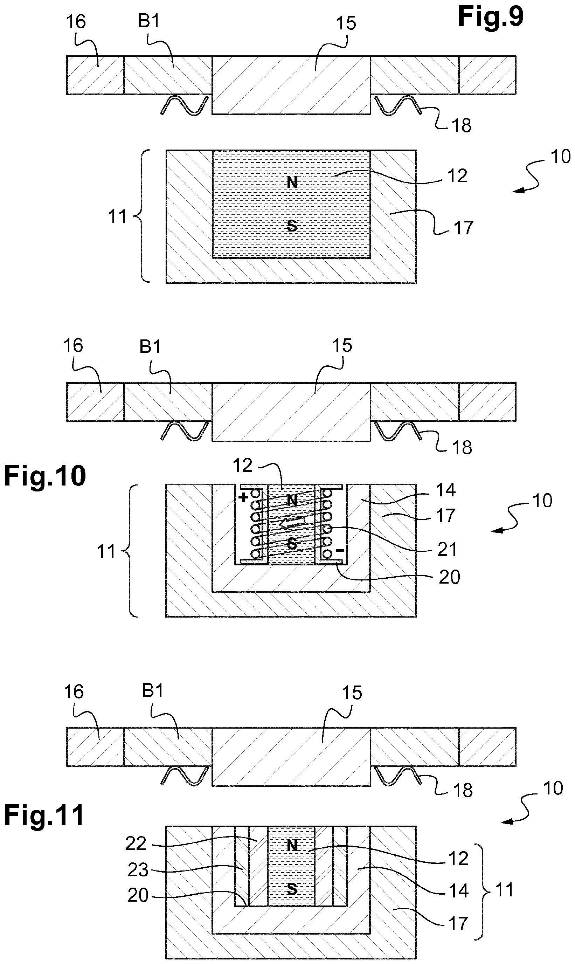

Une variante du dispositif 10 est montrée en figure 9: la pièce ferromagnétique 14 du dessous précédemment décrite est supprimée. Le flux magnétique F de l'aimant permanent 12 se referme ici dans l'air, ce qui implique un dimensionnement plus important de ce dernier pour exercer le même effort de connexion que celui des figures 7A et 7B. L'aimant permanent peut par exemple occuper toute la cavité de la pièce conductrice 17, comme montré en figure 9.

Tous les dispositifs de connexion 10 qui viennent d'être décrits ne sont pas déconnectables sans intervention de l'extérieur et donc ne permettent pas un démontage entre borne de sortie d'accumulateur et busbar sous tension/courant.

Pour résoudre ce problème, le dispositif 10 est modifié pour être piloté par alimentation d'un courant, comme montré en figure 10.

Ici, un mandrin électriquement isolant 20 entoure l'aimant permanent 12, et un fil électriquement conducteur formant une bobine 21 est enroulée autour du mandrin isolant. Le mandrin 20 peut par exemple être en plastique isolant, typiquement un thermoplastique du type polyéthylène, et le fil de bobine en cuivre.

Le dispositif 10 est ainsi configuré de sorte que :
i/ lorsque la bobine 21 n'est pas initialement alimentée électriquement, la force magnétique d'attraction de l'aimant permanent 12 sur la plaque de fermeture 15, dans la configuration du circuit magnétique fermé, maintient la connexion mécanique entre busbar B1 et pièce conductrice 17, et donc entre busbar B1 et la borne de sortie. Le contact électrique entre eux est réalisé par le biais de la rondelle 18.
ii/ lorsque la bobine 21 est alimentée électriquement dans un sens donné, elle produit un champ magnétique opposé à celui de l'aimant permanent 12, jusqu'à annuler la force d'attraction de l'aimant permanent, ce qui provoque la déconnexion mécanique entre busbar B1 et pièce conductrice 17, soit busbar B1 et borne de sortie. Le contact électrique entre eux est supprimé.

Ce mode de réalisation est également avantageux car il est possible de renforcer temporairement l'effort d'attraction de l'aimant permanent 12 en injectant dans la bobine un courant dans le sens opposé à celui de la phase ii/, ce qui crée un champ magnétique dans le même sens que celui de l'aimant permanent 12. Ainsi, on peut piloter plus précisément la fermeture entre pièces conductrices B1, 17 ou simplement la faciliter.

En lieu et place d'un bobine 21, on peut implanter une résistance chauffante électrique 22 comme montré en figure 11.

Plus précisément, cette résistance chauffante 22 entoure par exemple l'aimant permanent 12 et peut être entouré d'un isolant thermique 23, qui a pour fonction de concentrer vers l'aimant permanent 12 la chaleur produite par la résistance chauffante 22. De préférence, l'isolant thermique 23 peut être maintenu par un mandrin isolant électrique 20 comme celui décrit ci-avant. D'autres configurations géométriques peuvent être envisagées à condition de chauffer suffisamment l'aimant.

Un aimant permanent 12 est sensible à la température et perd ses propriétés magnétiques (devient amagnétique) au-delà d'une température critique appelée température de Curie. Cette température dépend des matériaux choisis pour l'aimant permanent et peut varier de 100°C à plus de 250°C. Dans le cadre de l'invention, la température de Curie de l'aimant permanent est choisie pour être comprise entre une valeur proche de 90% de la température d'auto-échauffement (T1) et une valeur proche de 110% de la température d'emballement thermique (T2) des accumulateurs du pack.

Ainsi, lorsqu'elle va être alimentée électriquement, la résistance chauffante 22 va chauffer localement l'aimant permanent 12 dimensionné pour que sa température dépasse la température de Curie.

L'aimant 12 n'exerçant plus de force d'attraction, la déconnexion mécanique et électrique a lieu entre pièces conductrices B1, 17. La démagnétisation de l'aimant permanent est définitive et donc la déconnexion selon cette variante l'est aussi.

La consommation électrique requise par l'alimentation de la bobine 21 ou la résistance chauffante électrique 22 d'un dispositif 10 est très faible, ce qui est avantageux pour un accumulateur métal-ion qui est par nature électriquement autonome.

En lieu et place d'une résistance chauffante électrique 22, on peut chauffer l'aimant par l'accumulateur lui-même. En effet, dans le cas d'un accumulateur métal-ion, sa température à cœur en emballement thermique, est compatible avec une température de démagnétisation d'un aimant permanent. Ainsi, la déconnexion électrique pourra être obtenue de manière passive grâce à l'emballement thermique de l'accumulateur défaillant.

Plusieurs types d'aimants permanents 12 existent et sont utilisables pour les dispositifs décrits. Les aimants en ferrite ou samarium cobalt sont très performants (fort champ coercitif) et sont ceux utilisés dans les dispositifs décrits précédemment. Ces aimants à hautes performances (potentiellement coûteux) sont nécessaires dans le design d'un dispositif selon l'invention car l'aimant permanent est de faible volume.

D'ailleurs les géométries montrées dans les dispositifs précédemment décrits sont schématiques à titre illustratif.

En pratique, un aimant permanent 12 doit être avantageusement être très fin : en effet, il se comporte comme un entrefer dans le circuit magnétique C, et cet entrefer doit être le plus faible possible pour que le flux et donc l'effort soit maximal. Également, le diamètre de l'aimant permanent 12 est limité par la taille de dispositif réduit.

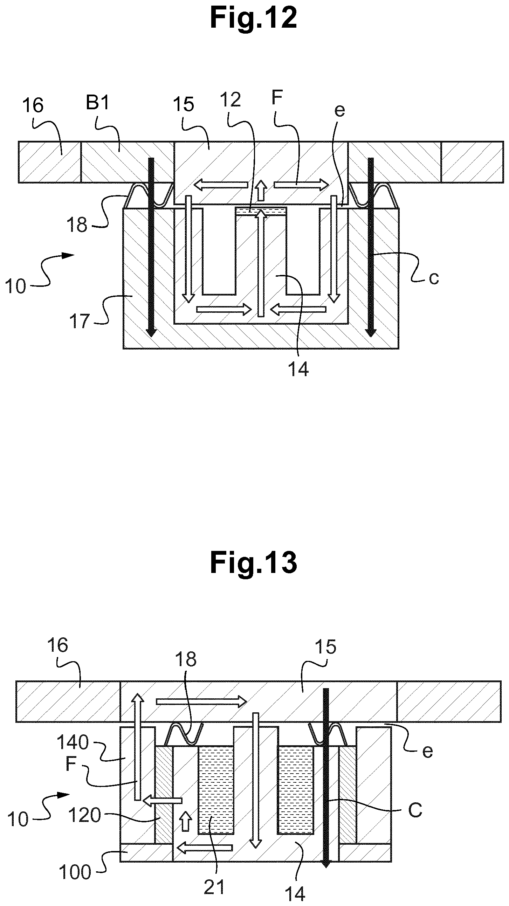

On a représenté en figure 12, un type d'aimant permanent 12 en ferrite ou samarium cobalt tel qu'il peut être réalisé concrètement sous la forme d'un disque et agencé dans un dispositif selon l'invention, destiné au passage de forts courants. Sur cette figure 12, on voit que la pièce ferromagnétique à cavité est remplacée par une pièce ferromagnétique 14 de forme adaptée, i.e. avec une paroi centrale en extrémité supérieure de laquelle l'aimant 12 sous la forme d'un disque est supporté. La pièce ferromagnétique est de préférence évidée entre sa paroi centrale et sa paroi périphérique vide pour avoir un gain de masse.

A titre d'exemple, les inventeurs ont réalisé un prototype d'un aimant 12 en samarium-cobalt sous la forme d'un disque d'1mm d'épaisseur et de 10mm de diamètre, destiné à une borne de sortie en tant que dispositif de connexion/déconnexion d'environ 20 mm de diamètre et 20 mm de hauteur. L'induction d'un tel aimant est de 1,1Tesla et l'effort de connexion obtenu avec cet aimant 12 est de 18N.

A titre d'exemple comparatif, par calcul, un aimant permanent 12 de 10mm de diamètre et 10 mm de hauteur génère seulement un effort de connexion de 0,5N.

Ces aimants permanents frittés 12, à hautes performances, conviennent parfaitement aux applications recherchées dans le cadre de l'invention.

En revanche, ils peuvent être coûteux et les mises en forme qu'il est possible d'obtenir avec les matériaux ferromagnétiques frittés sont limitées à des formes simples, comme plaques, disques, anneaux de petite taille.

C'est pourquoi les inventeurs ont pensé à agencer un plasto-aimant en lieu et place d'un aimant permanent fritté en ferrite ou en samarium-cobalt.

Un exemple d'agencement de plasto-aimant dans un dispositif de connexion 10 selon l'invention est montré en figure 13.

Sur cette figure 13, le plasto-aimant 120 de forme annulaire qui est agencé sur la périphérie du contact avec le circuit magnétique F réalisé avec deux pièces ferromagnétiques distinctes 14, 140 qui forment entre elle le volume annulaire dans lequel est logé le plasto-aimant 120. Le plasto-aimant 120 a donc la forme d'un cylindre de faible épaisseur et de hauteur importante.

Une pièce de liaison mécanique 100 peut être montée en force à l'aide d'une presse ou être soudée à l'interface entre les deux pièces ferromagnétiques 14, 140. On veille à s'assurer de la compatibilité entre les matériaux des différentes pièces lors de leur assemblage.

Comme visible sur cette figure 13, le flux magnétique F, est horizontal au niveau du plasto-aimant 120.

Un tel plasto-aimant 120 est avantageux car il permet d'avoir un entrefer de faible tout en bénéficiant d'un volume annulaire conséquent, et donc d'autoriser cette solution d'aimant moins performant que les aimants frittés 12.

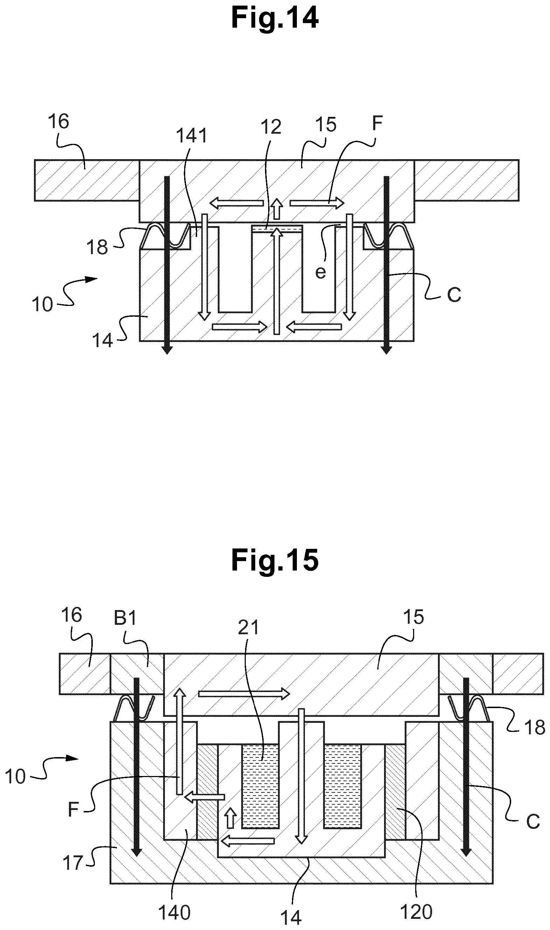

On a représenté en figure 14, un mode avantageux de réalisation de la pièce ferromagnétique 14 avec un aimant 12 sous la forme d'un disque comme en figure 12.

La pièce ferromagnétique 14 est réalisée avec un épaulement pour obtenir une différence de hauteur 141 qui permet à la fois d'obtenir une zone de contact magnétique et d'établir un bon contact électrique par l'intermédiaire d'une rondelle élastique 18 entre les deux pièces 14, 15 de la carcasse magnétique, c'est-à-dire sur le circuit magnétique C externe. L'agencement de la rondelle 18 permet de ne pas ajouter d'entrefer dans le circuit magnétique global ce qui serait préjudiciable à la tenue mécanique (réduction de l'effort).

La rondelle élastique 18 permet dans cette configuration un contact électrique ponctuel avec une pression de contact suffisante. La rondelle 18 peut être revêtue d'un ou plusieurs matériaux de contact adapté, typiquement à base d'un revêtement en Argent, pour améliorer la résistance de contact et éviter l'oxydation.

L'aimant permanent 12 dans la configuration de la figure 14 est de préférence un aimant fritté.

Ainsi, la configuration des figures 13 et 14 est avantageuse car le circuit magnétique constitué par les pièces ferromagnétiques 14, 15, typiquement en fer doux est fortement conducteur électrique et peut faire passer un courant de forte intensité à travers le dispositif, par l'intermédiaire de la rondelle élastique conductrice 18. Cela permet donc d'assurer une bonne conduction électrique entre la plaque de fermeture et le circuit magnétique.

On peut aussi envisager de faire passer un fort courant par une carcasse amagnétique comme montré en figure 15.

Dans cette figure 15, le courant ne passe plus à travers les pièces ferromagnétiques 14, 15 mais par l'intermédiaire de la carcasse amagnétique constituée par les pièces 17, B1 qui sont en cuivre par exemple.

Il est à noter que dans cette configuration de la figure 15, la pièce de liaison mécanique 100 peut être supprimée car la pièce de conduction électrique 17 maintient mécaniquement les différents éléments dans sa cavité.Les dispositifs de connexion/déconnexion magnétique qui viennent d'être décrits peuvent être intégrés pour partie directement dans les bornes de sortie d'accumulateur.

Cette intégration a pour but de réaliser un verrou magnétique entre au moins une borne de sortie d'accumulateur et un busbar, le verrou comprenant un aimant permanent et une bobine de commande coopérant avec une plaque de fermeture magnétique.

Comme cela ressort ci-après, un verrou magnétique est intégré dans une borne de sortie et la plaque de fermeture est du côté du busbar. A l'exception des configurations où l'on cherche un shunt électrique de l'accumulateur, on peut tout aussi bien envisager d'intégrer le verrou du côté du busbar et la plaque de fermeture magnétique dans la borne de sortie d'un accumulateur.

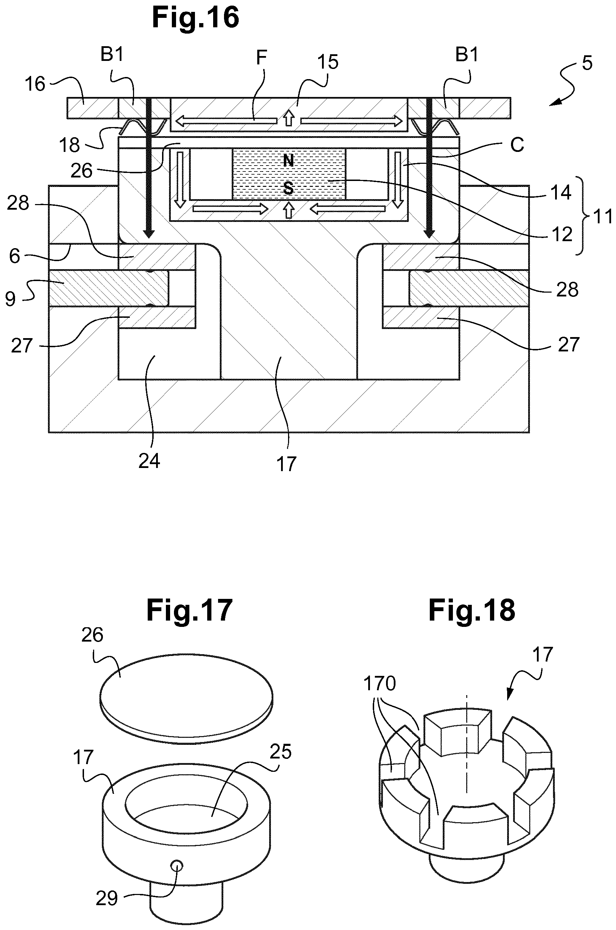

Un exemple de réalisation de borne de sortie 5 selon l'invention formée par une traversée est montrée en figure 16.

La traversée 5 est réalisée à travers un orifice débouchant de part et d'autre du couvercle 9 de boitier 6 d'un accumulateur A, qui comporte deux faces opposées.

La traversée 5 comprend une pièce femelle électriquement conductrice 24, et une pièce mâle électriquement conductrice 17 qui comprend la cavité 25 dans laquelle l'aimant permanent 12 est logé et qui est fermée par un capot d'obturation 26 également électriquement conducteur.

La cavité 25 loge également la pièce ferromagnétique 14 qui complète ici l'aimant permanent 12 pour former le verrou magnétique.

Une portion de la pièce mâle 17 est ajustée serrée dans un trou borgne de la pièce femelle 24.

Deux rondelles électriquement isolantes 27, 28 comportent chacune une portion d'appui en appui surfacique avec pression contre l'une des faces du couvercle 9 et une portion de guidage en saillie par rapport à la portion d'appui et en contact avec le bord de l'orifice.

En outre, chacune des pièces conductrices 17, 24 comporte une portion d'appui en appui surfacique avec pression contre une portion d'appui des rondelles 27.

Comme montré sur la figure 16, en configuration fermée du circuit magnétique, le flux magnétique F circule en boucle dans la borne 5 au travers de la pièce ferromagnétique 14 et de la pièce ferromagnétique 15 insérée dans le busbar B1, ce qui garantit la connexion mécanique entre borne 5 et busbar B1. Simultanément, la circulation du courant de puissance C se fait depuis le busbar B1 à travers le capot 26 et la pièce mâle 17 de la borne par le biais de la rondelle éventail 18.

La figure 17 montre en détail la pièce mâle conductrice 17 dont la cavité 25 loge l'aimant permanent 12 et qui est fermée par le capot 26, notamment fixé par soudage. Le capot 26 est de préférence dans le même matériau que la pièce mâle 17. L'épaisseur de ce capot est à définir en fonction de l'entrefer souhaité vis à vis de l'application.

Bien que non représentée, une bobine 21 ou une résistance électrique chauffante 22 pour la déconnexion magnétique de la borne 5 peut être logée dans la cavité 25.

Un orifice traversant 29 prévu dans la pièce mâle 17 permet de faire passer un fil électrique d'alimentation d'une telle bobine ou résistance électrique chauffante.

En lieu et place d'une pièce mâle conductrice 17 avec une cavité quasi-borgne 25 à l'exception d'un trou traversant 29 comme illustré en figure 17, on peut réaliser la pièce mâle conductrice 17, avec une ou plusieurs fentes 170 sur sa périphérie comme montré en figure 18. Cette variante est avantageuse car d'une part elle permet un gain de poids pour la pièce 17 et d'autre part elle laisse la possibilité de faire passer le fil d'alimentation de la bobine ou résistance électrique chauffante en plusieurs endroits.

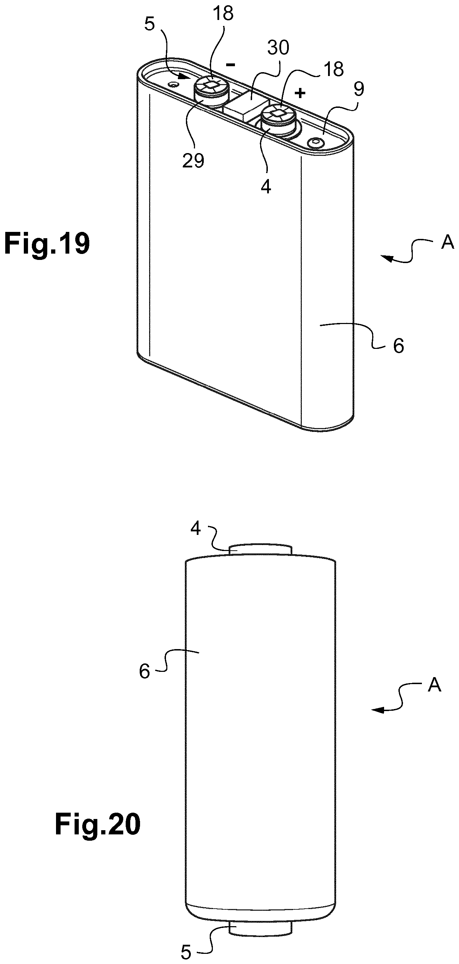

On a représenté en figure 19, un accumulateur métal-ion A de format prismatique dont les deux bornes de sortie 4, 5 agencées toutes deux sur le couvercle 9 du boitier 6, intègrent le verrou magnétique à aimant permanent 12. De préférence, chaque verrou magnétique comprend une pièce ferromagnétique 14 et une bobine 21 ou résistance électrique chauffante 22 pour la déconnexion éventuelle de l'accumulateur de busbars B1 et/ou B2.

Ainsi, en configuration fermée de chacun de leur circuit magnétique, chacune des deux bornes de sortie 4, 5 est verrouillée magnétiquement respectivement à un busbar B1 et/ou B2.

Comme visible sur cette figure 19, les rondelles éventail 18 peuvent être montées directement sur les bornes de sortie 4, 5.

L'alimentation électrique d'une bobine 21 ou résistance chauffante 22, en vue de la déconnexion magnétique entre un accumulateur A et les busbars B 1 et/ou B2, peut être réalisée à partir de la puissance de l'accumulateur A ou d'un autre accumulateur d'un pack-batterie, par un BMS qui permet notamment de détecter au préalable la défaillance de l'accumulateur.

Comme montré en figure 19, un tel BMS 30 peut être fixé directement sur le couvercle 9 du boitier et alimenté directement par des fils passant dans l'orifice traversant 29 des pièces mâles 17 des bornes 4, 5.

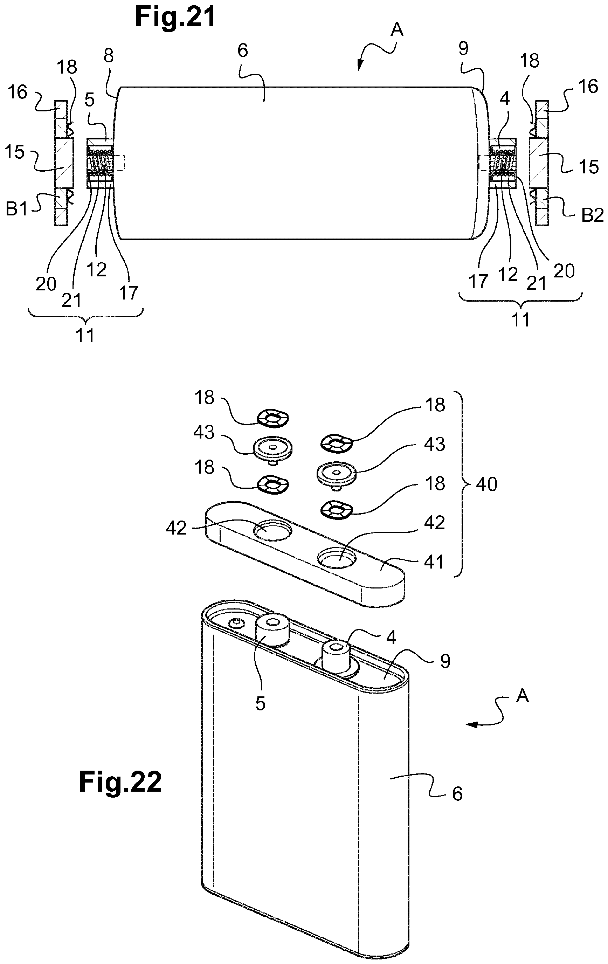

Les figures 20 et 21 illustrent un accumulateur métal-ion A de format cylindrique avec les deux bornes de sortie 4, 5 qui intègrent le verrou magnétique à aimant permanent 12, l'une étant agencée sur le couvercle 9 du boitier 6, et l'autre, à l'opposé, sur le fond du boitier 6.

Lorsqu'on souhaite mettre en œuvre les dispositifs de connexion/déconnexion magnétique 10 dans des accumulateurs existants, on peut intégrer ceux-ci dans des adaptateurs d'interface 40 comme illustré aux figures 22 à 24.

Un tel adaptateur d'interface 40 comprend tout d'abord un corps 41 de forme de préférence complémentaire au moins en partie avec le fond 8 ou le couvercle 9 du boitier de l'accumulateur métal-ion. Ce corps 41 vient donc se monter par emboitement sur le fond 8 et/ou le couvercle 9.

Dans le mode illustré aux figures 22 à 24, le corps 41 comprend deux logement traversant 42 à l'intérieur de chacun desquels une borne de sortie 4, 5 de l'accumulateur métal-ion peut venir se loger. Le corps est isolant ou bien isolé électriquement d'une des 2 bornes.

Deux verrous magnétiques 11 comprenant chacun un aimant permanent 12 entouré d'un mandrin isolant 20 avec sa bobine enroulée 21, sont intégrés dans le corps 41. Le corps 41 peut être surmoulé autour des verrous magnétiques 11.

Les verrous magnétiques 11 sont ici agencés aux extrémités latérales de l'adaptateur d'interface 40, à l'extérieur et côte-à-côte avec les bornes de sortie 4, 5.

Les connexions électriques entre les bornes de sortie 4, 5 et les busbars B1 et/ou, B2 en vis-à-vis sont assurées par des pièces électriquement conductrices 43 adaptées chacune pour être fixée avec contact électrique à une borne de sortie de l'accumulateur. En outre, pour garantir un contact électrique optimal, deux rondelles éventail 18, électriquement conductrices sont agencées de part et d'autre d'une pièce 43.

Un BMS 30 peut être inséré à l'intérieur du corps 41 de l'adaptateur d'interface 40. Ce BMS 30 est connecté aux deux verrous magnétiques 11 et aux bornes de sortie 4, 5 par des languettes conductrices 31, 32.

L'agencement en côte-à-côte des verrous magnétiques 11 et des bornes de sortie 4, 5 avec un adaptateur d'interface 40 permet d'obtenir une pression de contact plus élevée lors d'un shunt par effet de levier, et entre l'accumulateur et les busbars B1 et/ou B2 du fait des surfaces magnétiques disponibles entre verrous magnétiques 11 et pièces ferromagnétiques 15 qui peuvent être plus importantes.

Les adaptateurs d'interface 40 selon les figures 22 à 24, peuvent s'adapter à tous les types d'accumulateur existants, quelle que soit l'architecture mécanique des bornes.

Par ailleurs, un adaptateur d'interface 40 ajoute une surépaisseur, ce qui peut permettre de mieux gérer les forces mises en jeux à l'interface entre accumulateur et busbars.

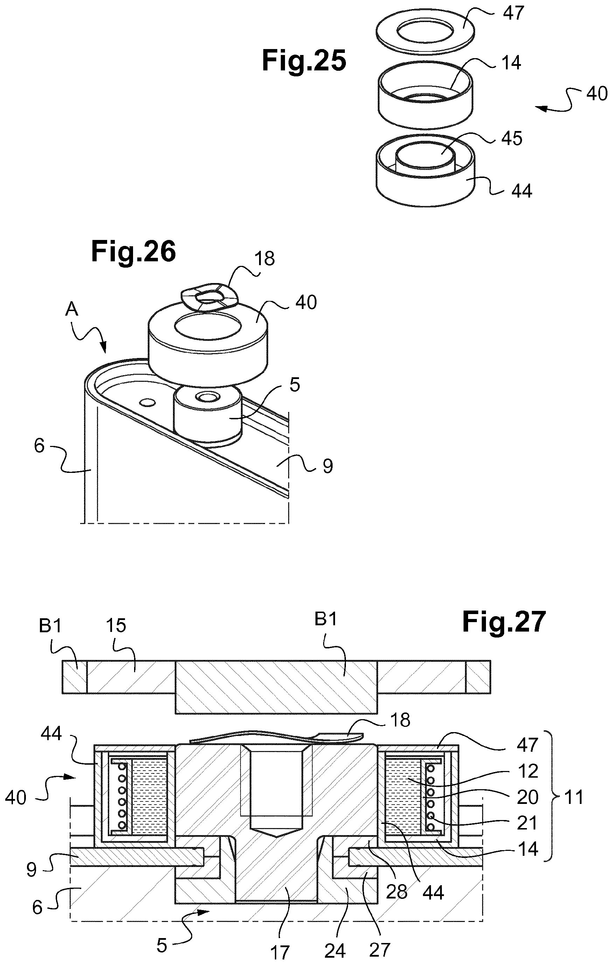

Un autre type d'adaptateur d'interface 40 est montré aux figures 25 à 27.

Cet adaptateur d'interface 40 comprend une enveloppe 44 en matériau isolant électrique, par exemple réalisée en matière plastique isolante. L'enveloppe peut également être en matériau conducteur en prenant soin de gérer les différentes isolations requises entre pièces à différents potentiels comme entre bornes et boitier par exemple. La forme de l'enveloppe est adaptée à la forme de la borne qui peut être cylindrique, parallélépipédique ou autre.

L'enveloppe 44 comprend une ouverture centrale débouchante 45, qui est adaptée pour venir se fixer, s'emmancher ou se visser ou se souder autour d'une borne de sortie d'un accumulateur A et une cavité 46 adaptée pour loger un verrou magnétique 11 conforme à l'invention, avec au moins une pièce ferromagnétique 14 de forme complémentaire qui vient s'emboiter à l'intérieur de la cavité 46.

Un capot d'obturation 47 ferme l'enveloppe 44 logeant le verrou magnétique 11.

Dans le mode illustré en figure 27, l'adaptateur d'interface 40 intègre un verrou magnétique 11 comprenant un aimant permanent 12 entouré d'un mandrin isolant 20 avec sa bobine enroulée 21.

L'adaptateur d'interface 40 est ici agencé autour d'une borne de sortie existante formée par une traversée 5, avantageusement réalisée selon l'enseignement de la demande de brevet FR2989836.

Ainsi, la traversée 5 est réalisée à travers un orifice débouchant de part et d'autre du couvercle 9 de boitier 6 d'un accumulateur A.

La traversée 5 comprend une pièce femelle électriquement conductrice 24, et une pièce mâle électriquement conductrice 17 dont une portion est ajustée serrée dans un trou de la pièce femelle 24.

Deux rondelles électriquement isolantes 27, 28 comportent chacune une portion d'appui en appui surfacique avec pression contre l'une des faces du couvercle 9 et une portion de guidage en saillie par rapport à la portion d'appui et en contact avec le bord de l'orifice.

En outre, chacune des pièces conductrices 17, 24 comporte une portion d'appui en appui surfacique avec pression contre une portion d'appui des rondelles 27.

Dans cette configuration de la figure 27, le verrou magnétique 11 est agencé de manière concentrique autour de la borne de sortie 5.

L'assemblage entre adaptateur d'interface 40 et borne de sortie selon la configuration concentrique de la figure 27 peut se faire par emmanchement à force ou soudage ou vissage autour de la borne de sortie 5 pourvu dans ce dernier cas d'un filetage externe non représenté.

Ici aussi, les adaptateurs d'interface 40 selon les figures 25 à 27, peuvent s'adapter à tous les types d'accumulateur existants, quelle que soit l'architecture mécanique des bornes. En particulier, ces adaptateurs annulaires 40 peuvent être mise en œuvre avec des accumulateurs au plomb dont l'emballage est en matière plastique isolante électriquement. L'illustration est faite sur un accumulateur à boitier rigide. Ce type d'adaptateur s'applique aussi aux accumulateurs à emballage souple.

La déconnexion magnétique qui vient d'être décrite sans autre mesure peut engendrer des problèmes d'arc électrique pour des courants de puissance élevés.

En effet, la connexion/déconnexion en charge d'accumulateurs électrochimiques peut entrainer l'apparition d'un arc électrique au niveau de leur connectique. Cet arc est très chaud, typiquement de plusieurs milliers de degrés, ce qui peut entraîner un emballement de la chimie et donc thermique de la batterie. Cet arc est d'autant plus problématique qu'un accumulateur métal-ion fonctionne en courant continu, l'absence de passage naturel du courant par 0 ne permet pas forcément l'extinction rapide de l'arc.

Une première solution pour parvenir à une extinction rapide consiste à allonger l'arc électrique en utilisant les champs magnétiques. L'allongement de l'arc va augmenter la surface d'échange avec le milieu ambiant et va conduire au refroidissement de l'arc. La température de l'arc diminuant, sa résistance augmente jusqu'à ce que le courant devienne nul et le milieu isolant.

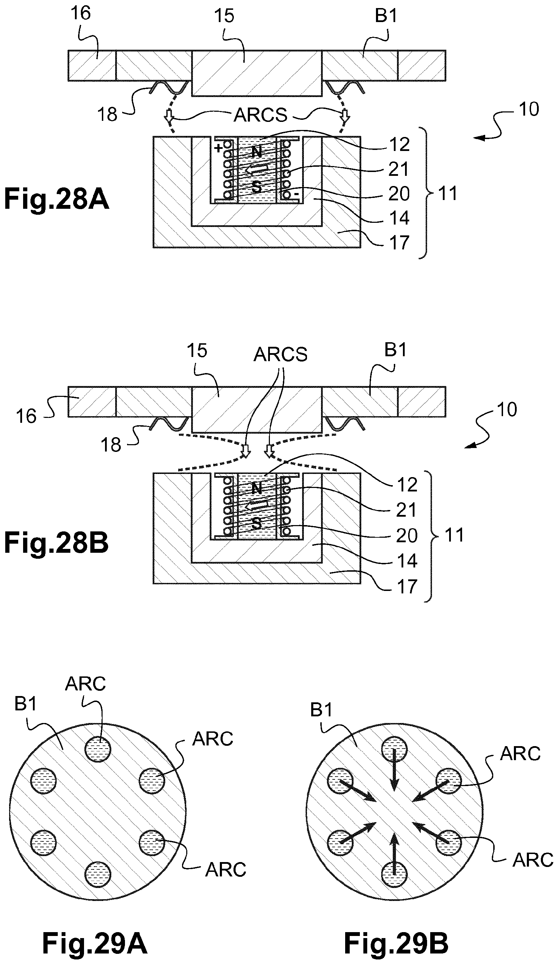

Un premier dispositif d'allongement magnétique est illustré sur les figures 28A, 28B et 29A, 29B.

Le dispositif de connexion/déconnexion magnétique 10 intègre ici nécessairement une rondelle éventail 18, électriquement conductrice, autour de la pièce ferromagnétique 15.

Ainsi, le contact électrique se fait entre la rondelle éventail conductrice 18 et un contact conducteur de la pièce conductrice 17, qui est de révolution cylindrique dans l'exemple illustré. Le contact a lieu en de multiples points de contacts.

Lorsque le contact s'ouvre pendant la déconnexion, plusieurs arcs électriques vont s'amorcer en ces différents points de contacts (figures 28A, 29A).

Le courant dans ces arcs, qui se comportent comme des conducteurs électriques est dans le même sens. Ces arcs électriques vont donc s'attirer suivant la loi de Laplace, ce qui va les déformer comme montré sur la figure 28B et par là même allonger le chemin et augmenter la surface d'échange avec le milieu ambiant pour parvenir à l'extinction des arcs.

Par le choix de dimensionnement de la rondelle éventail 18, on veille à ce que les arcs soient suffisamment proches les uns des autres, typiquement quelques mm, afin que la force de Laplace entre les arcs soit suffisante.

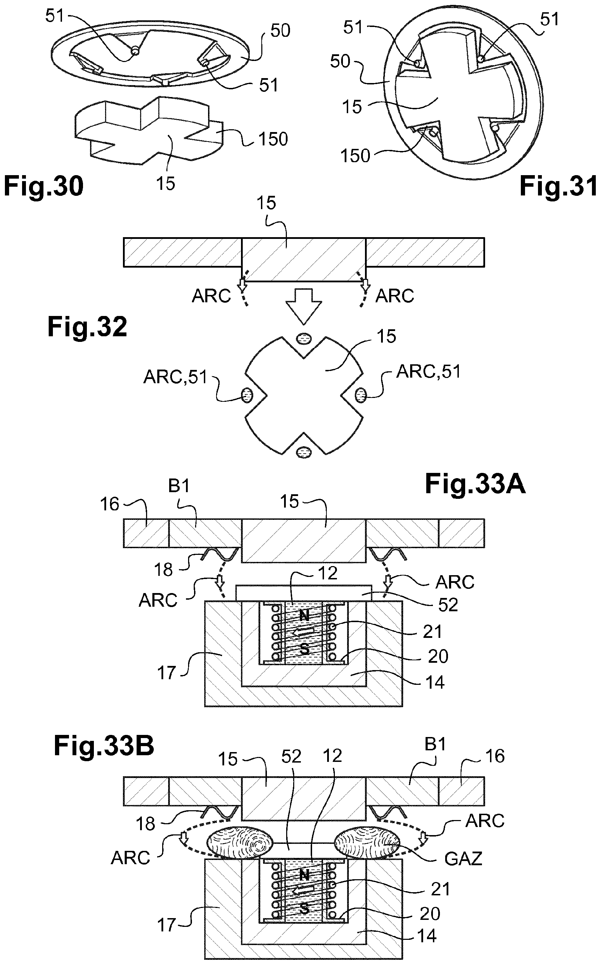

Un deuxième dispositif d'allongement magnétique est illustré sur les figures 30, 31 et 32. Ce deuxième dispositif peut être complémentaire du premier dispositif des figures 27A et 28B.

Ici, la pièce ferromagnétique 15 est réalisée avec des encoches 150, par exemple en forme de V, en vue de dessus.

Une rondelle de contact électrique de forme particulière 50 est prévue. Cette rondelle 50 est sous la forme d'un anneau relié électriquement à l'un des busbars.

La rondelle 50 est pourvu de picots flexibles 51 à sa périphérie intérieure agencés chacun dans une encoche 150 de la pièce ferromagnétique 15.

Dans la configuration de fermeture du circuit magnétique de connexion, chaque picot 51 est en contact électrique avec la pièce conductrice 17 d'une borne de sortie 4 ou 5. De fait, les picots flexibles 51 sont un peu enfoncés du fait de leur élasticité pour compenser les jeux et obtenir la pression de contact souhaitée.

Lors de la déconnexion mécanique entre borne de sortie et busbar, avec suppression du contact électrique entre rondelle 50 et borne de sortie, des arcs électriques entre picots 50 et pièce conductrice 17 de la borne de sortie vont être créés. Ces arcs vont générer des champs magnétiques qui vont déformer les arcs vers la pièce ferromagnétique de fermeture 15, qui va ainsi les refroidir jusqu'à leur extinction.

De manière plus précise, à l'ouverture du contact, on va avoir l'apparition d'arcs électrique comme précédemment qui vont générer des champs magnétiques notamment dans la pièce ferromagnétique 15 à proximité . Une force F de Laplace va s'exercer entre chaque arc électrique et ce champ magnétique qui est canalisé par la pièce 15 de perméabilité très supérieure à celle de l'air.

Comme précédemment l'arc électrique va se déformer vers l'intérieur et va être attiré vers la pièce ferromagnétique 15. Cette dernière étant bonne conductrice de la chaleur par rapport à l'air, va absorber une grande partie de l'énergie thermique de l'arc et va le refroidir très fortement entrainant son extinction. Il peut même y avoir une fusion locale de cette pièce de fermeture 15, ce qui va absorber une énergie considérable (chaleur lente de liquéfaction voire vaporisation). On veille bien entendu à dimensionner les pièces pour compenser l'usure progressive induite éventuellement par l'absorption de l'énergie thermique de l'arc.

Une deuxième solution pour parvenir à une extinction rapide consiste à générer au moment l'apparition de l'arc électrique un gaz sous pression au centre du contact qui va chasser ce dernier vers l'extérieur. On allonge ainsi l'arc vers l'extérieur pour le refroidir et le souffler.

Un dispositif d'extinction de l'arc par soufflage de gaz sous pression est illustré en figures 33A et 33B. Pour ce faire, une pièce 52 en matière isolante électrique, ayant un bas point de vaporisation typiquement inférieur à 250°C, par exemple une matière thermoplastique de type polyéthylène, est agencé au centre du verrou magnétique sur le dessus de celui-ci. La température de fusion de cette pièce 52 doit être de préférence inférieure à la température de curie de l'aimant permanent pour pouvoir souffler l'arc sans endommager les propriétés magnétiques de l'aimant.

Lors de l'apparition de l'arc électrique, cette pièce 52 à bas point de fusion va se vaporiser sous l'effet de la chaleur générée par l'arc et ainsi générer du gaz localement sous pression. En effet, l'échauffement dû à l'arc étant rapide, le gaz sous pression généré n'a pas le temps de se dissiper. Ce gaz sous pression va chasser l'arc vers l'extérieur du contact électrique et ainsi l'allonger entrainant son extinction (figure 33B).

La pièce 52 à bas point de fusion peut être agencée dans l'entrefer, entre verrou magnétique 11 et pièce ferromagnétique 15, à l'intérieur de la rondelle 18. On peut prévoir que cette pièce 52 constitue avec le mandrin isolant 20 d'enroulement de la bobine 21, une seule et même pièce.

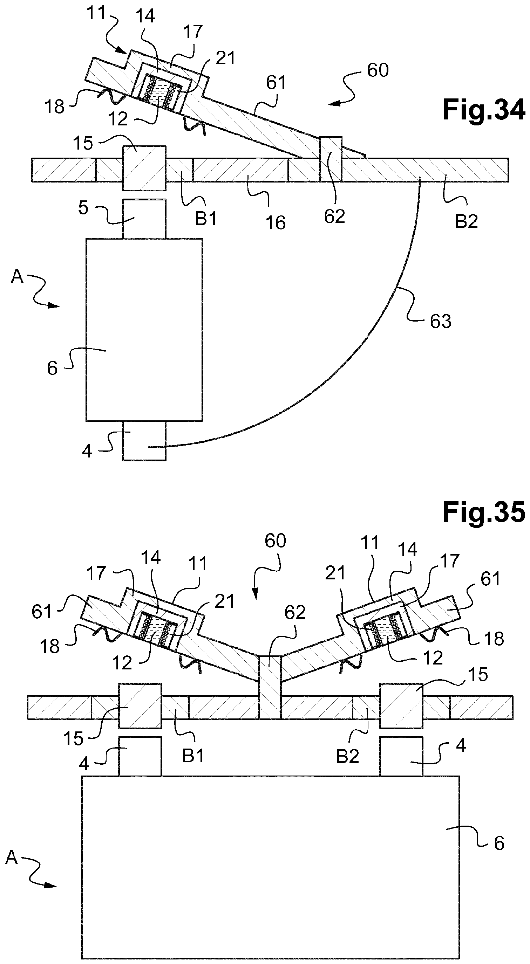

On a représenté en figure 34 un exemple de dispositif de shunt magnétique 60 selon l'invention, destiné à assurer un shunt au sein d'un pack-batterie et à assurer ainsi une continuité de fonctionnement de ce dernier.

Le dispositif de shunt 60 comprend une lame électriquement conductrice 61, flexible, fixée à l'une de ses extrémités à un point de fixation 62 sur une partie conductrice de l'un des busbars. La lame 61 peut être en cuivre-béryllium.

A l'autre des extrémités de la lame flexible 61 est insérée un verrou magnétique 11 qui comprend une cavité conductrice 17 à l'intérieur de laquelle est logé une pièce ferromagnétique 14 logeant elle-même un aimant permanent 12 et une bobine 21 autour de l'aimant 12.

En position ouverte, comme représenté, l'élasticité de la lamelle conductrice doit être suffisante pour compenser l'attraction de l'aimant sur la plaque ferromagnétique sur la partie fixe, de sorte que le dispositif reste ouvert.

Lorsque l'on souhaite fermer le contact entre pièces conductrices 17, B1, on applique un courant dans la bobine 21 dans le sens adéquat, de sorte que le champ magnétique généré par la bobine renforce celui de l'aimant permanent 12. L'effort généré par le champ magnétique de la bobine et de l'aimant conjugué doit alors être supérieur à celui de la lame flexible 61. Le contact peut alors se fermer et son verrouillage magnétique effectué par le verrou magnétique 11 avec la pièce ferromagnétique fixe 15.

Lorsque l'on coupe le courant de commande de fermeture dans la bobine 21, l'aimant permanent 12 peut assurer seul le maintien car l'entrefer entre le verrou magnétique 11 et la pièce ferromagnétique 15 est réduit, ce qui implique un effort de verrouillage magnétique supérieur à celui de la lame flexible 61. Le dispositif de shunt 60 reste alors en position fermée, même en absence de courant dans la bobine de commande.

Pour ouvrir le dispositif de shunt 60, il faut injecter un courant opposé dans la bobine 21, de sorte que le champ magnétique généré par cette dernière soit opposé à celui de l'aimant permanent 12 et annule le champ résultant. Lorsque l'effort de maintien dû à ce champ résultant devient inférieur à celui de la lame flexible 61, le dispositif de shunt 60 peut s' ouvrir.

Le courant de commande d'ouverture dans la bobine peut alors être coupé car la lame 61 revient dans la position initiale, c'est-à-dire que la force magnétique d'attraction de l'aimant 12 est inférieure à la force d'ouverture de la lame 61.

La figure 35 illustre une variante qui vient d'être décrite selon laquelle le dispositif à shunt 60 est dupliqué à l'exception de la fixation des lames: deux lames flexibles 61 sont fixées chacune à l'une de leurs extrémités à un point de fixation électriquement isolant et intègrent à l'autre de leurs extrémités un verrou magnétique 11. Le fonctionnement du dispositif de shunt 60 dupliqué est identique à celui décrit en référence à la figure 34.

En plus, le dispositif de shunt 60 dupliqué permet avantageusement de réaliser la déconnexion simultanée des deux bornes 4, 5 d'un accumulateur, alors que dans l'exemple de la figure 34, une seule borne 5 est concernée par le système de verrou, l'autre borne étant reliée par exemple par un câble souple 63 au busbar B2.

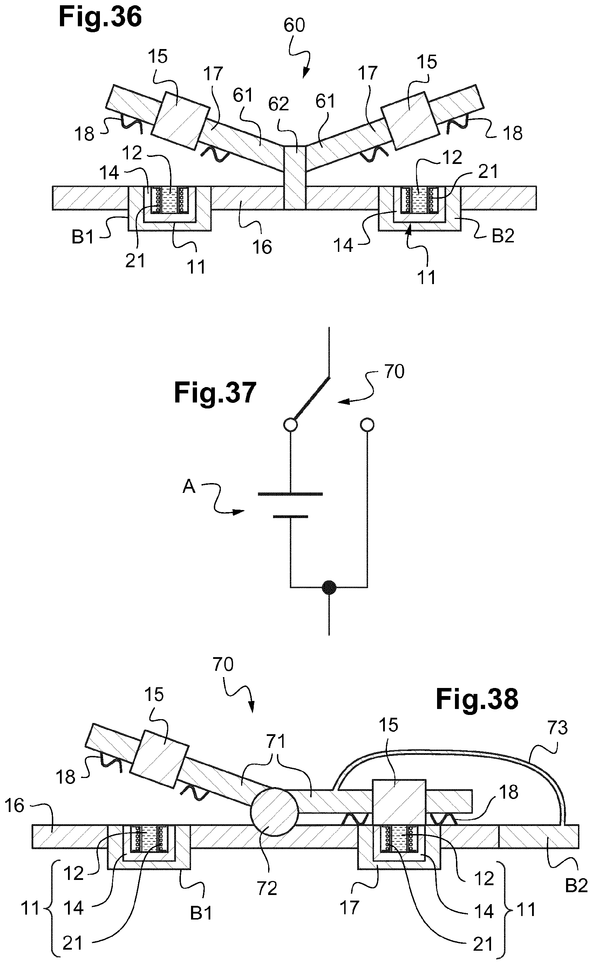

Une autre variante du dispositif de shunt 60 est illustrée en figure 36: les verrous magnétiques 11 sont ici insérés dans la partie inférieure fixe, les pièces conductrices formant les cavités de logement des aimants permanents 12, bobines 21 et pièces ferromagnétiques 17 étant alors réalisées dans les busbars B1, B2 ou dans des pièces conductrices reliées à ces dernières. Cette variante de la figure 36 peut permettre de simplifier le raccordement des bobines de commande à l'unité électronique de pilotage notamment le BMS d'un accumulateur.

On a représenté en figures 37 et 38, un exemple de dispositif de shunt magnétique 70 selon l'invention, destiné à constituer un inverseur au sein d'un pack-batterie et à assurer non seulement une continuité de fonctionnement de ce dernier mais également à shunter un circuit d'un ou plusieurs accumulateurs.

Comme illustré en figure 38, le dispositif inverseur 70 comprend une lame rigide 71 articulée en son centre par une articulation 72. L'articulation 72 de cette lame rigide ne permet pas de réaliser simplement une connexion électrique de puissance de qualité. Aussi, l'amenée du courant à cette lame 71 peut être réalisée à l'aide d'une tresse métallique 73, de préférence en cuivre soudée électriquement par points pour améliorer cette liaison électrique.

La lame rigide 71 intègre à chacune de ses extrémités une pièce ferromagnétique 15 destinée chacune à fermer un circuit magnétique avec l'un des verrous magnétiques 11 agencé dans la partie inférieure du dispositif comme déjà décrit.

Sur la figure 38, lorsque le contact de droite entre lame 71 et pièce conductrice 17 est fermé et verrouillé par le verrou magnétique 11, le contact de gauche est ouvert.

L'aimant permanent du contact de droite étant beaucoup plus proche de la pièce ferromagnétique 15 en vis-à-vis que celui du contact de gauche avec sa pièce 15 de gauche en vis-à-vis, la force d'attraction magnétique est très supérieure du côté droit et le dispositif inverseur 70 reste verrouillé dans cette position.

Pour faire basculer la lame rigide pivotante 71 et donc parvenir à l'inversion, on procède de la façon suivante.

Un BMS commande l'injection d'un courant dans la bobine 21 de droite, de sorte que le champ magnétique généré par la bobine s'oppose à celui de l'aimant permanent 12 de droite.

L'effort de maintien du contact de droite décroit fortement et s'annule au bout d'un certain temps.

A un moment, le couple d'attraction, défini comme étant le produit entre la force d'attraction et la longueur d'une des parties de la lame, exercé par l'aimant permanent 12 de gauche devient supérieure au couple de maintien du contact de droite et la lame 71 bascule alors en ouvrant le contact de droite et en fermant le contact de gauche.

Le BMS peut éventuellement commander l'injection d'un courant dans la bobine du contact de gauche pour augmenter transitoirement le champ magnétique généré par l'aimant permanent de gauche. Cela permet de gérer la vitesse de basculement de la lame rigide 71.

Lorsque la lame rigide 71 a basculé, le verrou magnétique 11 de gauche maintient le contact de gauche verrouillé dans cette nouvelle position et l'alimentation des bobines de commande 21 peut être coupée.

Un fonctionnement inverse du dispositif 70 est bien sûr possible pour repasser dans l'état initial.

Au lieu d'agencer les verrous magnétique 11 dans la partie fixe inférieure du dispositif inverseur 70, on peut les implanter dans la lame rigide 71.

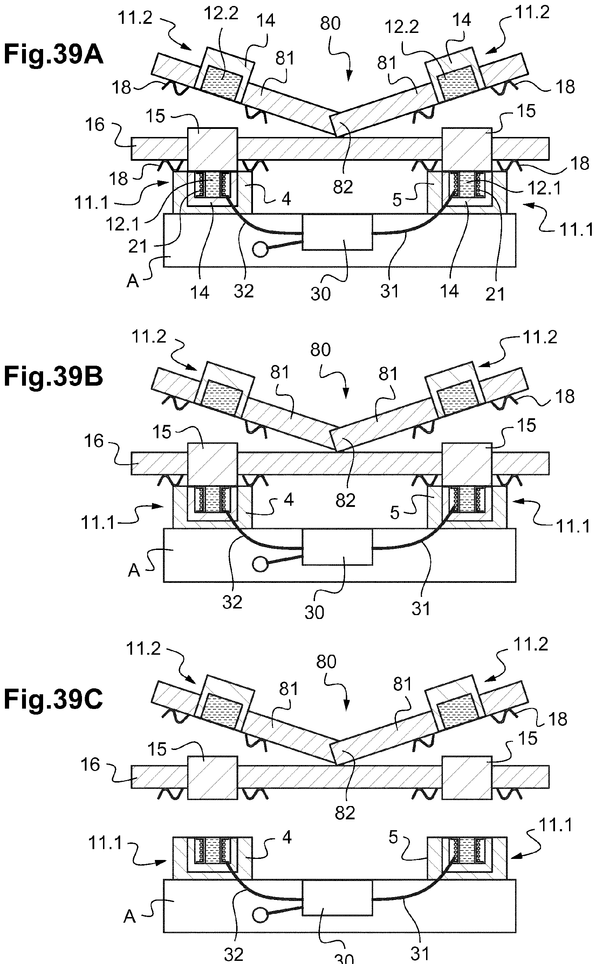

Les figures 39A à 39E montrent les différentes phases d'un dispositif 80 à la fois de connexion/déconnexion entre un accumulateur A et des busbars B1, B2, et de shunt de cet accumulateur A déconnecté car défaillant.

Ici, un verrou magnétique 11.1 est intégré dans chacune des bornes de sortie 4, 5, de l'accumulateur.

Chaque verrou 11.1 de borne 4, 5 comprend une cavité conductrice 17 à l'intérieur de laquelle est logé une pièce ferromagnétique 14 logeant elle-même un aimant permanent 12.1 et une bobine 21 autour de l'aimant 12.1.

Deux pièces ferromagnétiques 15 sont insérées chacune dans l'une de deux busbars B1, B2, formant des plaques de fermeture d'un circuit magnétique avec le verrou magnétique 11 de l'une ou l'autre des bornes de sortie 4,5.

Deux lames électriquement conductrices 81, flexibles sont fixées chacune à l'une de ses extrémités à un point de fixation 82. Chaque lame 81 comprend une cavité à l'intérieur de laquelle est logé uniquement un aimant permanent 12.2 formant un verrou magnétique 11.2.

Comme visible, sur ces figures 39A à 39E et expliqué par suite, un aimant permanent 12.2 d'une lame flexible 81 est en regard d'un aimant permanent 12.1 d'un verrou magnétique 11.1 de borne 4, 5, avec leurs pôles de même signe, positif dans l'exemple illustré, qui se font face.

Le fonctionnement d'un dispositif de connexion/déconnexion et de shunt magnétique 80 est le suivant.

Lorsque le BMS 30, intégré dans le boitier d'accumulateur, détecte un fonctionnement normal de l'accumulateur, la force magnétique d'attraction des aimants permanents 12.1 des bornes de sortie 4, 5 respectivement sur les plaques de fermeture 15 en regard, dans la configuration des circuits magnétiques fermés, assure la connexion mécanique entre lesdites borne de sortie 4, 5 et les busbars B1 et/ou B2 avec contact électrique entre eux (figure 39A).

Dans cette configuration, les aimants permanents 12.2 des lames flexibles 81 sont répulsés par les aimants permanents tel que les lames flexibles 81 ne peuvent pas être en contact électrique avec les busbars B1, B2, c'est-à-dire à distance d'eux (figure 39A).

Lorsque le BMS 30 détecte une défaillance de l'accumulateur A, il alimente à partir de la tension et l'énergie de l'accumulateur, les bobines 21 des bornes de sortie 4, 5, par le biais des fils d'alimentation électrique intégrés dans l'accumulateur A (figure 39B).

La défaillance de l'accumulateur peut être détectée à partir d'au moins l'un des paramètres suivants : la température de peau, la température interne, la tension et la résistance de la cellule.

L'alimentation des bobines 21 est faite dans un sens tel qu'elles génèrent chacune une force magnétique opposée à la force magnétique d'attraction des aimants permanents 12.1 des bornes 4, 5 jusqu'à assurer la déconnexion mécanique et électrique entre bornes de sortie 4, 5 et respectivement les deux busbars B1, B2 (figure 39C).

Cette déconnexion provoque une chute par gravité de l'accumulateur.

Pour l'alimentation des bobines 21, avantageusement on fait croître le courant depuis 0 jusqu'à une valeur prédéfinie avec une rampe suffisamment lente 1 à 2 s par exemple, pour laisser le temps à l'accumulateur de tomber par gravité, lorsque le champ magnétique résultant, c'est-à-dire celui résultant des aimant permanents 12.1 et des bobines 21, devient insuffisant pour compenser le poids de l'accumulateur.

Les champs magnétiques générés par les bobines 21 peuvent continuer à croitre un peu lorsque l'accumulateur est tombé, et cela n'a pas de conséquence. Le courant est coupé au bout d'une durée fixée, de 2 s par exemple.

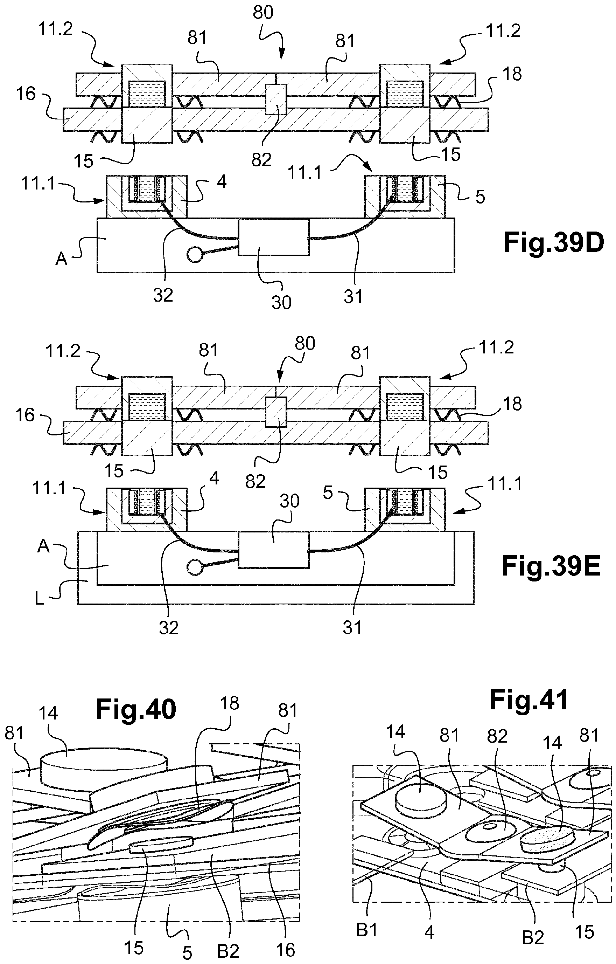

Simultanément ou quasi-simultanément à la chute de l'accumulateur, du fait de l'absence de répulsion magnétique, la fermeture du circuit magnétique a lieu entre les aimants permanents 12.2 des lames flexibles 81 et les plaques de fermeture 15 et la connexion électrique entre les busbars B1 et B2 par le biais des lames flexibles 81 (figure 39D).

Autrement dit, la déconnexion mécanique et électrique entre bornes de sortie 4, 5 et busbars B1 et B2 s'accompagne simultanément de la connexion électrique sur les busbars B 1 et B2 par les lames flexibles conductrices 81. Cette connexion électrique sur les busbars B1 et B2 constitue un shunt de l'accumulateur A tout en rétablissant la continuité électrique à la place de l'accumulateur A.

Pour finaliser le fonctionnement du dispositif, on peut réaliser la chute de l'accumulateur A guidé dans un logement contenant un liquide caloporteur L (figure 39E). Ainsi, l'accumulateur A noyé dans le liquide caloporteur L est inerté. Le liquide caloporteur peut être celui d'un circuit de refroidissement d'un pack-batterie dans lequel l'accumulateur est intégré ou un liquide indépendant dudit circuit de refroidissement dont l'amenée dans le logement est pilotée par le BMS ou un liquide résultant du changement d'état d'un matériau à changement de phase (MCP) obtenu par l'échauffement de l'accumulateur.

En fonction de la tension et courant de l'accumulateur, en cas de risque d'arc électrique lors de la chute de l'accumulateur par gravité provoquant sa déconnexion mécanique et électrique, on peut mettre en œuvre les moyens précédemment décrits en référence aux figures 28A à 33B.

En lieu et place d'une bobine 21, on peut agencer dans chaque borne de sortie 4, 5 une résistance électrique chauffante. L'alimentation de cette résistance chauffante est conçue pour chauffer les aimants permanents 12.1 à une température supérieure à leur température de curie. Les aimants permanents 12.1 sont alors démagnétisés et ce de façon définitive.

L'avantage par rapport aux bobines 21 est que les aimants permanents définitivement démagnétisés, ne peuvent pas empêcher le verrouillage magnétique des lames flexibles 81, même si l'accumulateur déconnecté pour une raison quelconque reste proche des plaques de fermeture 15. Ici, en cas d'échauffement important de l'accumulateur défaillant, par exemple par suite d'un emballement thermique, la démagnétisation des aimants permanents 12.1 peut être obtenue par l'échauffement lui-même sans nécessiter de contrôle électronique, ni de BMS.

Que la déconnexion soit provoquée par une bobine 21 ou une résistance électrique chauffante, un accumulateur défaillant présente une tension et capacité minimales pour l'alimentation électrique. Cette énergie minimale est donc avantageusement mise à profit pour la déconnexion de l'accumulateur en défaut.

Typiquement, à titre indicatif, un verrou magnétique couramment utilisé pour la fermeture de portes avec une force de contact de 300 daN nécessite pour son déverrouillage un pulse de 12V/550mA pendant quelques secondes.

Dans le cas d'un accumulateur Li-ion, cette énergie de déverrouillage pour un accumulateur à 3V correspond à un courant de 2A pendant quelques secondes ce que l'accumulateur défaillant peut fournir sans difficulté.

A la place du BMS 30 propre à l'accumulateur défaillant, on peut utiliser d'autres systèmes de contrôle électronique qui piloteront l'alimentation électrique des bobines 21 ou résistances électriques chauffantes. Il peut s'agir du BMS général d'un pack-batterie ou d'un accumulateur non défaillant qui serait dédié pour cela au sein d'un pack-batterie.

Les figures 40 et 41 illustrent un exemple de réalisation concret d'un dispositif de connexion/déconnexion et shunt magnétique 80 qui vient d'être décrit : les lames ou languettes 81, de type en cuivre béryllium, sont fixées par un rivet 82 à un substrat isolant 16 dans lequel sont insérés les busbars B1 et/ou B2.

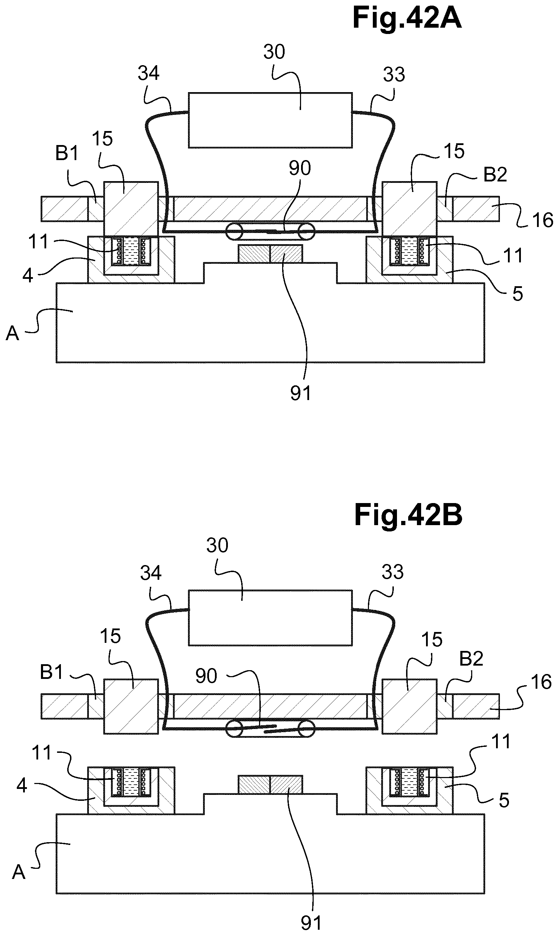

Les figures 42A et 42B illustrent une variante de détection passive d'une déconnexion magnétique d'un accumulateur A depuis les busbars B 1 et/ou B2. Ici la partie fixe du dispositif de connexion/déconnexion 10 intègre un interrupteur à relais 90, communément appelé interrupteur reed.

Cet interrupteur reed 90 est en regard d'un aimant permanent de détection 91 agencé dans l'accumulateur.

Plus précisément, l'aimant permanent de détection 91 en regard de l'interrupteur reed 90 ferme ce dernier lorsque l'accumulateur A est connectée aux busbars B1 et/ou B2 (figure 42A).

Lorsque l'accumulateur A est déconnectée, l'aimant permanent 91 est trop loin pour fermer l'interrupteur 90 qui s'ouvre donc (figure 42B). Cette ouverture provoque une ouverture de circuit formé avec un BMS 30 et les liaisons électriques 33, 34. Ainsi, de manière complètement passive, le BMS 30 peut détecter le fait que l'accumulateur A est déconnecté des busbars B1, B2. L'aimant de détection 91 peut être un aimant dédié ou bien l'aimant permanent du verrou magnétique de l'accumulateur.

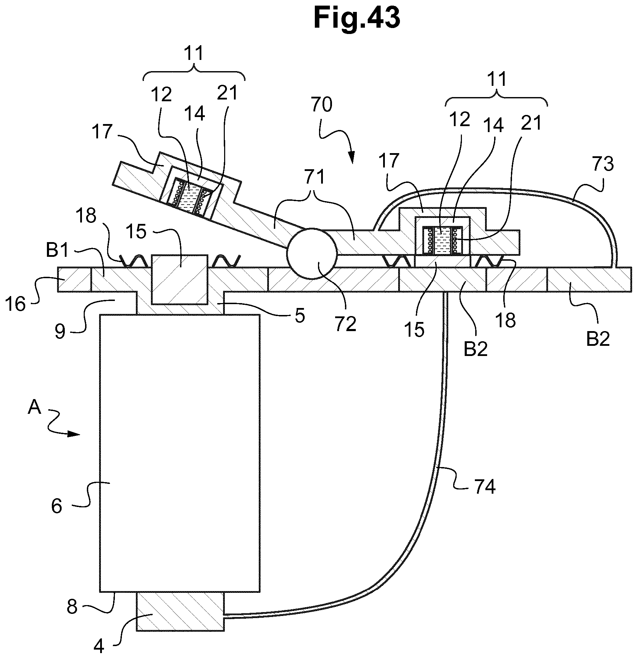

La figure 43 montre une mise en œuvre avantageuse d'un inverseur 70 illustré en figure 38. Dans cette mise en œuvre, la déconnexion magnétique d'un accumulateur A avec shunt peut se faire par uniquement l'une de ses bornes 5.

Dans l'exemple illustré de la figure 43, l'accumulateur A est de géométrie cylindrique et comprend une borne de sortie 5 sur l'un des côtés de l'emballage 6, par exemple le couvercle 9, et l'autre borne de sortie 4 est sur l'autre des côtés de l'emballage 6, par exemple sur le fond 8.

Dans cet exemple de la figure 43, l'accumulateur est agencé à la verticale. Mais on peut tout aussi bien envisager de l'agencer à l'horizontal.

Ici, la borne de sortie 5 du haut est connectée électriquement au busbar B1 par l'un des verrous magnétiques 11 de l'inverseur 70 (à gauche sur la figure 43). Cette connexion assure la tenue mécanique de l'accumulateur A.

L'autre borne de sortie 4 est connectée électriquement au busbar B2 par un fil ou clinquant électriquement conducteur 74, typiquement en cuivre, qui peut être avantageusement entouré d'une gaine électriquement isolante, non représentée.

Tout comme celui représenté en figure 38, l'inverseur 70 comprend une lame rigide 71 articulée en son centre par une articulation 72. L'amenée du courant à cette lame 71 est également réalisée d'une tresse métallique 73, de préférence en cuivre soudée électriquement par points pour améliorer cette liaison électrique.

La lame rigide 71 intègre à chacune de ses extrémités, le cas échéant dans une pièce conductrice 17, un verrou magnétique 11 avec aimant permanent 12 muni d'une bobine 21.

Des pièces ferromagnétiques 15 destinées chacune à fermer un circuit magnétique avec l'un des verrous magnétiques 11 est agencée sur les busbars B1 et B2 ainsi que dans la borne de sortie 5.

En configuration de connexion, le contact de gauche entre lame 71 et la borne de sortie 5 est fermé et verrouillé par le verrou magnétique 11, le contact de droite est ouvert.

L'aimant permanent du contact de gauche étant beaucoup plus proche de la pièce ferromagnétique 15 en vis-à-vis que celui du contact de droite avec sa pièce 15 de droite en vis-à-vis, la force d'attraction magnétique est très supérieure du côté gauche et le dispositif inverseur 70 reste verrouillé dans cette position.

Pour faire basculer la lame rigide pivotante 70 et donc parvenir à la déconnexion de l'accumulateur avec réalisation du shunt par l'inversion, on procède de la façon suivante.

Un BMS commande l'injection d'un courant dans la bobine 21 de gauche de sorte que le champ magnétique généré par la bobine s'oppose à celui de l'aimant permanent 12 de gauche.

Lorsque le verrou magnétique 11 de gauche s'ouvre, seule la borne de sortie 5 est déconnectée magnétiquement et l'accumulateur chute par gravité.

Simultanément, la lame rigide 71 a basculé, le verrou magnétique 11 de droite maintient le contact de droite verrouillé dans cette nouvelle position (figure 43) et l'alimentation de la bobine de commande 21 peut être coupée.

Ainsi, dans ce mode de réalisation, la déconnexion mécanique et électrique de l'accumulateur A est réalisée uniquement sur une des bornes de sortie, ce qui provoque la chute par gravité de ce dernier. L'inversion simultanée réalisée sur le busbar B2 par l'inverseur 70 constitue un shunt de l'accumulateur A tout en rétablissant la continuité électrique à la place de l'accumulateur A.

Ici encore, au lieu d'agencer les verrous magnétique 11 dans la lame rigide 71, du dispositif inverseur 70, on peut les implanter dans les busbars B1 et B2.

Il va de soi qu'on prévoit une longueur suffisante du clinquant ou fil 74 pour ne pas gêner l'accumulateur A lors de sa chute.

Avec l'ensemble des dispositifs de connexion/déconnexion magnétique 10, 60, et le cas échéant de shunt magnétique 80 avec le cas échéant une fonction inverseur 70, qui viennent d'être décrit, suivant une défaillance d'un accumulateur ou le besoin d'une modification de l'architecture électrique d'un pack-batterie, on peut mettre en œuvre une déconnexion électrique et/ou mécanique d'un accumulateur, reconfigurer une architecture électrique d'un pack-batterie, le cas échéant en réalisant un shunt d'un ou plusieurs accumulateurs du pack.

Certains modes de réalisation permettent une désactivation du ou des aimants permanents sans aucune intervention de BMS, c'est-à-dire des modes complètement passifs. Ces modes peuvent être avantageusement mis en œuvre si l'on souhaite un maximum de sécurité pour le fonctionnement d'un accumulateur individuel ou d'un pack-batterie.

Autrement dit, avec l'ensemble des dispositifs de connexion/déconnexion magnétique 10, 60, et le cas échéant de shunt magnétique 80 avec le cas échéant une fonction inverseur 70, on peut envisager la réalisation de différentes architectures de pack-batterie P, à des fins de pilotage actif à la demande et/ou à des fins de sécurité avec continuité de fonctionnement du pack.

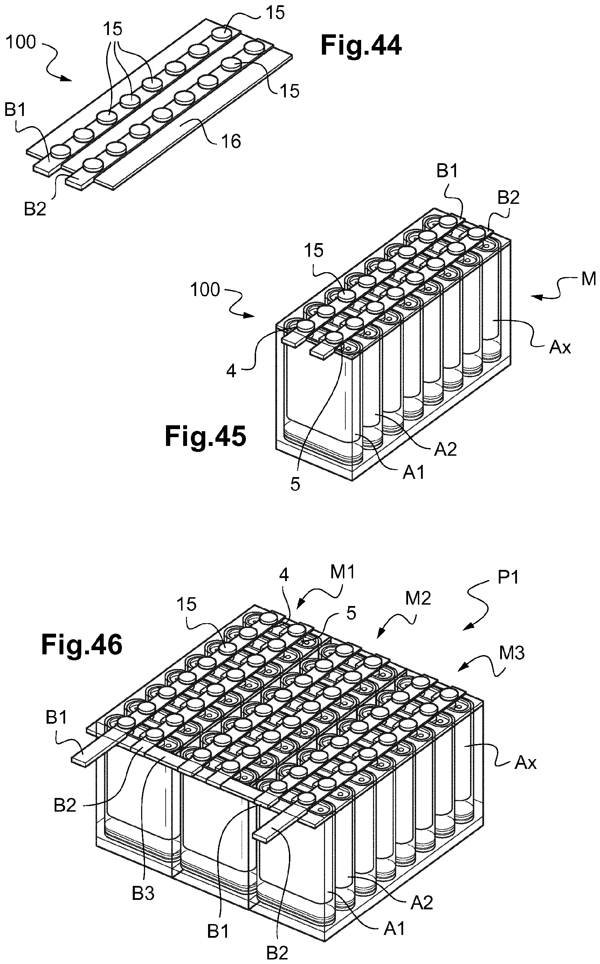

Les figures 44 à 46 montrent la réalisation au moyen de dispositifs de connexion/déconnexion magnétiques 10, d'un pack-batterie P1 comprenant la mise en parallèle de plusieurs accumulateurs A1,...Ax par des busbars B1, B2 pour former une branche M1 reliée électriquement en série par le biais de busbars B3 avec d'autres branches similaires M2, M3.

Pour chaque branche M1, M2, M3, un ensemble de connectique 100 comprenant un substrat isolant électriquement 16 dans lequel sont insérées des busbars B1, B2 est réalisé (figure 44).

Après avoir logé la pluralité des accumulateurs A1...Ax de chaque branche dans des logements 102 d'une structure en nid d'abeille 101, l'ensemble de connectique 100 est fixé par la pluralité de dispositifs de connexion/déconnexion magnétique 10 (figure 45).

Puis, la mise en série des branches M1, M2, M3 est réalisée au moyen de busbars B3.

Si l'on souhaite réaliser uniquement la déconnexion à l'unité d'accumulateurs défaillants, chaque accumulateur A1, ...Ax de chaque branche M1, M2, M3 comprend ici un BMS 30 qui lui est propre.

Dans le cas où l'on veut réaliser un pilotage actif d'un tel pack-batterie P1, par exemple pour augmenter la puissance du pack P1 à la demande, il est possible de couper ou d'alimenter temporairement une branche au moyen d'un ou plusieurs dispositifs de connexion/déconnexion magnétique avec shunt 60 et/ou d'un ou plusieurs inverseurs 70. Dans ce cas, de préférence, chaque branche M1, M2, M3 comprend un BMS unique qui peut commander l'injection d'un courant électrique dans les verrous magnétiques 11.

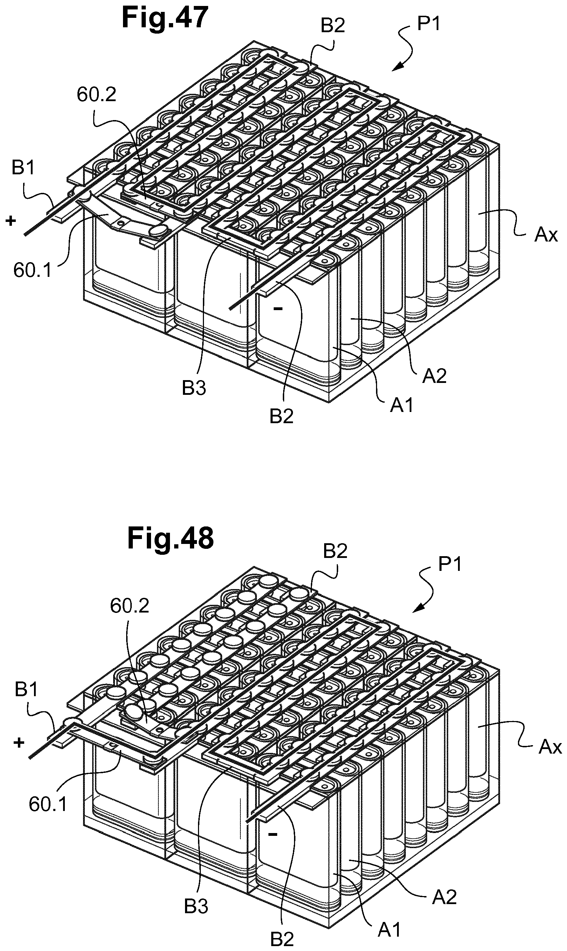

Un pack-batterie P1 avec deux dispositifs de connexion/déconnexion magnétique avec shunt 60.1, 60.2 est ainsi montré en figures 47 et 48.

En fonctionnement pleine puissance du pack P1, l'un des dispositifs 60.1 (le plus à l'extérieur du pack en figures 47 et 48) n'est pas activé et l'autre des dispositifs 60.2 (le plus à l'intérieur du pack en figures 47 et 48) agit comme un busbar B3 de liaison série entre deux branches M1, M2 (figure 47). L'ensemble des branches est alors connecté. Le sens du courant est indiqué en figure 47.

En cas de nécessité ou de volonté de fonctionnement de moindre puissance du pack P1, le BMS global du pack P1 active le dispositif 60.1 qui est inactif en pleine puissance et ouvre le dispositif 60.2 qui est actif en pleine puissance (figure 48). La branche M1 est alors shuntée pour fournir moins de puissance.

Si l'on souhaite améliorer encore la sûreté de fonctionnement du pack lors du passage de pleine puissance à une moindre puissance, on peut mettre en œuvre en lieu et place des deux dispositifs 60.1, 60.2, un unique inverseur 70 qui, dans une de ses positions de bascule, réalise la connexion électrique entre les busbars B1 et B2 pour connecter l'ensemble des branches M1, M2...et, dans l'autre de ses positions de bascule, réalise le shunt de l'une des branches M1, M2.....

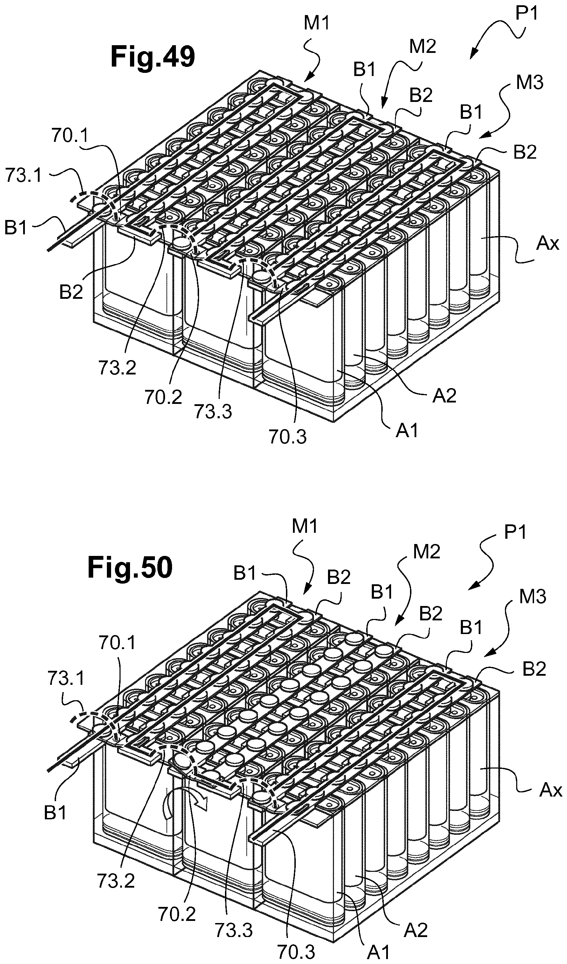

Ce mode de réalisation est illustré aux figures 49 et 50. En fonctionnement à pleine puissance illustrée en figure 49, la connexion en série électrique entre deux branches M1-M2, M2-M3 est assurée par un inverseur 70.1, 70.2, 70.3 décrit et illustré en référence à la figure 43. Ainsi, la tresse métallique 73.1, 73.2, 73.3 assure la liaison électrique entre le busbar B2 de la branche précédente au busbar B1 de celle suivante.

En cas de nécessité, notamment en cas de défaillance de la branche M2, ou de volonté de fonctionnement de moindre puissance du pack P1, le BMS global du pack P1 active l'inverseur 70.2 de que sa lame rigide pivote (figure 50). La branche M2 est alors shuntée et le pack P1 peut fonctionner avec la puissance des autres branches M1 et M3 toujours connectées en série.

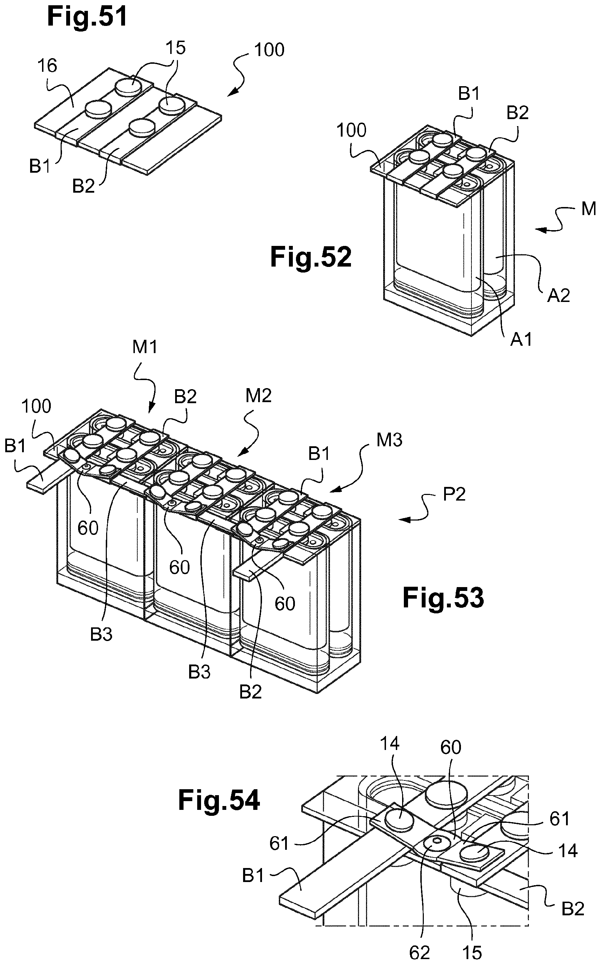

Les figures 51 à 53 montrent la réalisation au moyen de dispositifs de connexion/déconnexion magnétiques 60, d'un pack-batterie P2 comprenant la mise en parallèle de plusieurs accumulateurs A1,...Ax par des busbars B1, B2 pour former une branche M1 reliée électriquement en série par le biais de busbars B3 avec d'autres branches similaires M2, M3.

Dans cette architecture, une défaillance d'un accumulateur A1 peut avoir une forte incidence sur son accumulateur en parallèle A2,...Ax. En effet, la perte de capacité de l'accumulateur défaillant A1 ne sera pas compensée par l'accumulateur A2 adjacent.

Il faut donc shunter la branche M1, M2 ou M3 de l'accumulateur défaillant afin d'assurer les performances électriques du pack-batterie P2 et assurer une continuité de fonctionnement ou de service de P2.

L'actionnement d'un dispositif 60 en bout de la branche contenant l'accumulateur défaillant réalise le shunt magnétique souhaité et donc la continuité de fonctionnement de P2.

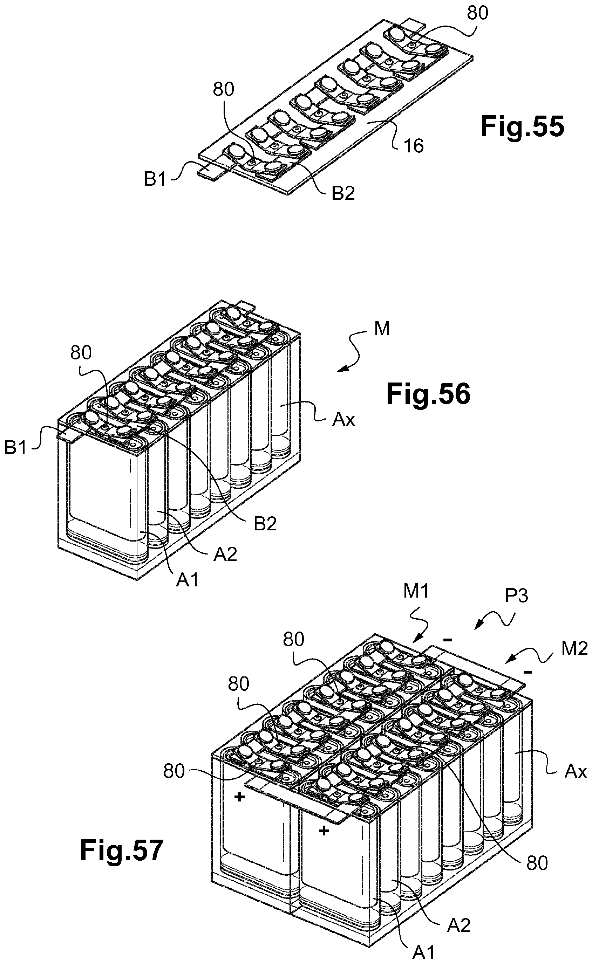

Les figures 55 à 57 montrent la réalisation au moyen de dispositifs de connexion/déconnexion magnétiques avec shunt 80, d'un pack-batterie P3 comprenant la mise en série de plusieurs accumulateurs A1,...Ax par des busbars B1, B2 pour former une branche M1 reliée électriquement en parallèle par le biais de busbars B3 avec d'autres branches similaires M2, M3.

Dans cette architecture de pack-batterie P3, chaque accumulateur A1, ...Ax de chaque branche M1, M2, M3 comprend un BMS 30 qui lui est propre.

Dans cette architecture, une défaillance d'un accumulateur donné peut avoir une forte incidence sur l'ensemble du pack P3. En effet, la perte d'un accumulateur en série peut avoir pour conséquence une diminution de la tension de la branche qui contient l'accumulateur défaillant, avec, au final, un déséquilibre entre les branches. Un déséquilibre peut entrainer une surtension interne au pack P3, ce qui peut provoquer l'emballement général de ce dernier.

Dans cette architecture, il est important de considérer la chimie des accumulateurs, qui doivent être capables de supporter une surtension. Par exemple, dans le cas d'un accumulateur Li-ion, le lithium fer phosphate LFP a une courbe de décharge dite « plate », ce qui permet d'avoir une plage homogène lors de la charge ou de la décharge. Également, il faut atteindre au minimum le double de la tension nominale pour apercevoir un début d'emballement, ce qui permet d'absorber une différence de tension entre les deux branches et de rééquilibrer l'ensemble du système.

Chaque accumulateur défaillant peut être déconnecté puis shunté au moyen d'un dispositif 80.

Ainsi, la sécurité et la continuité de service du pack-batterie P3 sont assurés constamment quel que soit l'accumulateur défaillant au moyen des dispositifs 80 dédiés individuellement pour chaque accumulateur du pack P3.

Grâce aux dispositifs de connexion/déconnexion magnétique, le cas échéant avec shunt magnétique qui viennent d'être décrits, on obtient un temps d'assemblage et en coût de production d'un pack-batterie, vraiment réduits par rapport aux process d'assemblage des accumulateurs selon l'état de l'art par un ou plusieurs bus-bar par soudage, vissage ou tous autres procédés.

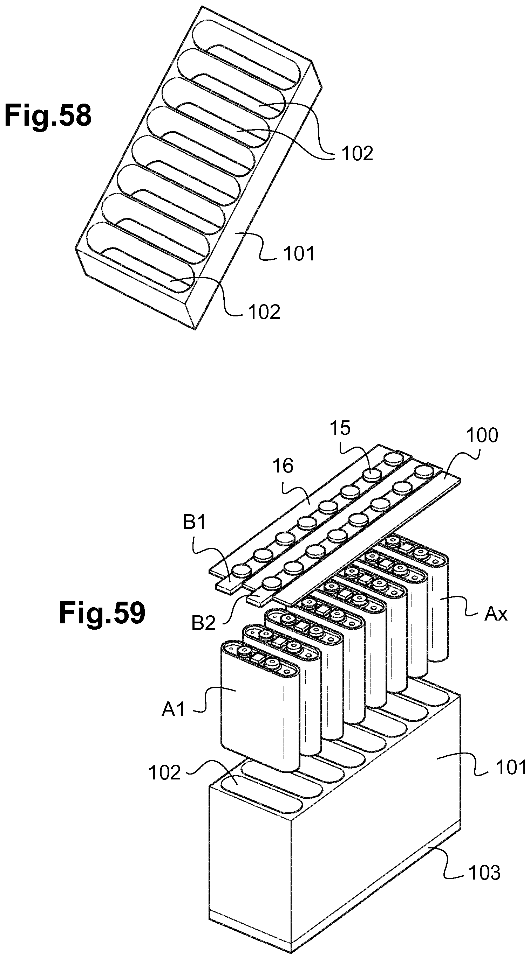

Les étapes d'assemblage d'un pack-batterie P3, dont certains des composants sont illustrés en figures 58 et 59 peuvent être les suivantes.
Etape a/ : on vient positionner un ensemble de connectique 100 intégrant des busbars B1, B2 dans un substrat isolant électrique 16 à l'envers, avec les lames flexibles 81 assurant les continuités de service positionnés sur le dessous du substrat 16. Etant donné les forces magnétiques mises en jeux, les lames 81 sont en position fermées, c'est-à-dire verrouillées magnétiquement sur les busbars B1, B2.
Etape b/ : on vient fixer par clipsage une structure en nid d'abeille 101 en matériau isolant électrique, comprenant les logements sous forme d'alvéoles 102 adaptés pour loger chacun un accumulateur, sur l'ensemble de connectique 100.
Etape c/ : on insère les accumulateurs A1, ...Ax dans les alvéoles 102, chacune de forme adaptée pour réaliser un guidage d'un accumulateur de forme complémentaire. A ce stade, chaque accumulateur est en lévitation magnétique au-dessus des busbars B1, B2 du fait de la répulsion passive entre aimants permanents 12.1, 12.2 des verrous magnétiques 11.1, 11.2 des dispositifs 80.
Etape d/ : on applique ensuite successivement en dessous de chaque accumulateur un champ magnétique que l'on fait varier pour annuler le champ dans le verrou 11.2 du shunt. Ce dernier va s'ouvrir sous l'effet du ressort de la lame flexible 81 et l'accumulateur va descendre en position. La décroissance du champ magnétique de montage en dessous de l'accumulateur va permettre sa connexion avec verrouillage sur les busbars B1, B2 par le biais des verrous magnétiques 11.1. Le contrôle du champ magnétique permet d'obtenir une connexion douce et progressive. Les forces en jeux dans les verrous magnétiques 11.1 sont suffisantes pour supporter le poids des accumulateurs et avoir une faible résistance de contact.
Etape e/ : On vient alors fermer le pack-batterie P3 ainsi formé par un socle 103 incluant le système de refroidissement du pack-batterie.

Outre le temps et le coût d'assemblage réduits, le procédé avec les étapes décrites a pour avantage important de ne pas manipuler de pièces nues sous tension qui nécessitent usuellement des habilitations contraignantes (de type TST).

L'invention n'est pas limitée aux exemples qui viennent d'être décrits ; on peut notamment combiner entre elles des caractéristiques des exemples illustrés au sein de variantes non illustrées.

D'autres variantes et améliorations peuvent être envisagées sans pour autant sortir du cadre de l'invention.

De manière générale, les verrous magnétiques 11 conformes à l'invention peuvent être agencées soit dans les parties fixes, soit dans les parties mobiles de l'ensemble des dispositifs de connexion/déconnexion magnétique avec shunt et inverseurs illustrés. Plus précisément, à l'exception des configurations où l'on recherche le shunt d'un accumulateur, on peut envisager d'intégrer un verrou magnétique, soit dans une borne de sortie d'un accumulateur, soit du côté d'un busbar, et respectivement la plaque de fermeture magnétique coopérant avec le verrou magnétique, soit du côté du busbar, soit dans la borne de sortie d'un accumulateur.

Dans le cadre de l'invention, toute bobine peut être alimentée par n'importe lequel des accumulateurs d'un pack-batterie. Selon une variante avantageuse, lorsqu'elle est intégrée dans une borne de sortie d'un accumulateur, elle peut être alimentée directement par ce dernier.

En ce qui concerne le montage avantageux d'un pack-batterie selon l'invention, initialement avant leur connexion mécanique et électrique avec verrouillage, les accumulateurs sont chacun en lévitation magnétique pour éviter le contact non souhaité qui serait dû à une force magnétique s'opposant au poids de l'accumulateur. Le champ magnétique appliqué qui permet cette lévitation, doit être variable pour pouvoir gérer une approche progressive entre l'accumulateur et le busbar auquel il doit être connecté mécaniquement et électriquement et verrouillé.

On peut envisager plusieurs manières d'appliquer ce champ magnétique variable :
- par le biais d'un outillage externe muni d'un aimant permanent dont On fait alors varier le champ magnétique soit en l'éloignant de l'accumulateur, soit en utilisant une bobine externe, soit en utilisant la bobine du verrou intégrée dans l'une des bornes de l'accumulateur ;
- par le biais des lames du côté du busbar, qui intègrent alors un verrou magnétique comprenant un aimant permanent et une bobine dont on fait varier le champ magnétique.

Si dans l'ensemble des exemples illustrés, les emballages des accumulateurs conformes à l'invention sont des emballages rigides (boitiers), l'invention s'applique bien entendu à tous les accumulateurs à emballage souple dans lesquels un verrou magnétique ou une plaque de fermeture magnétique correspondante peut être intégré(e).

Si dans l'ensemble des exemples illustrés, les boitiers des accumulateurs conformes à l'invention sont électriquement conducteurs, l'invention s'applique bien entendu à tous les accumulateurs à boitiers électriquement isolants.

En outre, si dans l'ensemble des exemples illustrés, les bornes de sortie des accumulateurs conformes à l'invention ont une forme générale cylindrique, l'invention s'applique bien entendu à toutes les formes géométriques de bornes (section carrée ou rectangulaire, hexagonale...).

### Liste des références citées :

[1] Xuning Fenga, et al. « Key Characteristics for Thermal Runaway of Li-ion Batteries » Energy Procedia, 158 (2019) 4684-4689.
[2] M. Soka et al. « Rôle of thermomagnetic curves at preparation of Ni Zn ferrites with Fe ions deficiency», Journal of Electrical Engineering, Vol.61 N°7/s, 2010, pp163-165.
[3] K Murakami « The characteristics of Ferrite cores with low Curie temperature and their application », IEEE Transactions on magnetics, Volume: 1, Issue: 2, June 1965.

## Revendications

1. Pack-batterie (P) comprenant :
- une pluralité de batteries ou d'accumulateurs électrochimiques (A1-An), comprenant chacun :
• un boitier (6) ou un emballage souple,
• une première borne de sortie (4) et une deuxième borne de sortie (5) de polarité opposée à la première borne de sortie;
au moins une des bornes de sortie comprenant:
• une pièce électriquement conductrice (17),
• un verrou magnétique (11) comprenant un aimant permanent (12);
- au moins une pièce ferromagnétique (15) solidaire d'une barre de connexion électrique, dite busbar, formant une plaque de fermeture d'un circuit magnétique avec le verrou magnétique de la borne de sortie ;
le pack-batterie étant configuré de sorte que :
i/ lors d'un fonctionnement normal de l'accumulateur, la force magnétique d'attraction de l'aimant permanent de la borne de sortie sur la plaque de fermeture d'un premier busbar, dans la configuration des circuits magnétiques fermés, assure la connexion mécanique et électrique entre la borne de sortie et le premier busbar,
ii/ lors d'une défaillance de l'accumulateur provoquant une surchauffe de ce dernier, l'aimant permanent de la borne de sortie chauffe et au moins jusqu'à une température à partir de laquelle il perd ses propriétés magnétiques, jusqu'à la déconnexion mécanique entre la borne de sortie et le premier busbar, **caractérisé en ce que** la déconnexion mécanique provoque une chute par gravité de l'accumulateur.

2. Pack-batterie (P) selon la revendication 1, comprenant:
- au moins une lame électriquement conductrice (60), flexible, fixée à l'une de ses extrémités à un autre busbar ou autre partie de busbars, comprenant un aimant permanent;
le pack-batterie étant configuré de sorte que :
lors de l'étape i/, l'aimant permanent de la lame flexible est répulsé par celui de la borne de sortie tel que la lame flexible ne peut pas être en contact électrique avec le premier busbar,
lors de l'étape ii/, du fait de l'absence de répulsion magnétique de l'accumulateur défaillant ayant chuté, la connexion électrique entre le premier et l'autre busbar par le biais respectivement de la lame flexible, qui réalise par-là le shunt de l'accumulateur.

3. Pack-batterie (P) selon l'une des revendications précédentes, la température de Curie de l'aimant permanent étant choisie pour être comprise entre une valeur proche de 90% de la température d'auto-échauffement (T1) et une valeur proche de 110% de la température d'emballement thermique (T2) des accumulateurs du pack.

4. Pack-batterie (P) selon l'une des revendications précédentes, l'aimant permanent étant un aimant fritté (12) ou un plasto-aimant (120), l'aimant fritté étant de préférence à base de terres rares, de préférence en samarium-cobalt ou néodyme-fer-bore, ou de préférence en ferrite ou de préférence en alliage aluminium-nickel cobalt, le plasto-aimant étant de préférence à base de terres rares, de préférence en samarium-cobalt ou néodyme-fer-bore, ou en ferrite.

5. Pack-batterie (P) selon l'une des revendications précédentes, au moins une des deux bornes de sortie de chaque accumulateur comprenant au moins une deuxième pièce ferromagnétique agencée autour ou à l'intérieur de la pièce électriquement conductrice, la deuxième pièce ferromagnétique étant fermée par la plaque de fermeture dans la configuration de fermeture du circuit magnétique.

6. Pack-batterie (P) selon la revendication 5 en combinaison avec la revendication 4, comprenant au moins une troisième pièce ferromagnétique (140) agencée autour de la deuxième pièce ferromagnétique (14) en formant un logement annulaire dans lequel est logé un plasto-aimant, la bobine étant agencée à l'intérieur de la première pièce ferromagnétique.

7. Pack-batterie (P) selon l'une des revendications précédentes, chaque pièce ferromagnétique étant en fer doux.

8. Pack-batterie (P) selon l'une des revendications précédentes, chaque lame flexible étant en cuivre-béryllium.

9. Pack-batterie (P) selon l'une des revendications précédentes, chaque pièce électriquement conductrice (17) de chaque verrou étant dans le même matériau qu'une borne de sortie d'accumulateur.

10. Pack-batterie (P) selon l'une des revendications précédentes, chaque pièce électriquement conductrice (17) de chaque verrou étant en aluminium ou en cuivre.

11. Pack-batterie (P) selon l'une des revendications précédentes, comprenant au moins une rondelle (18) ondulée ou éventail électriquement conductrice, agencée telle que, dans la configuration de fermeture des circuits magnétiques de connexion, elle assure un contact électrique entre la borne de sortie munie d'un verrou et l'un des busbars.

12. Pack-batterie (P) selon l'une des revendications 2 à 10, comprenant au moins une rondelle (18) ondulée ou éventail électriquement conductrice, agencée telle que, dans la configuration de fermeture des circuits magnétiques de shunt, elle assure un contact électrique entre la lame et l'un des busbars.

13. Pack-batterie (P) selon la revendication 11 ou 12, chaque rondelle étant en alliage cuivre-phosphore.

14. Pack-batterie (P) selon l'une des revendications précédentes, la première ou la deuxième borne de sortie étant agencée sur une face du boitier ou de l'emballage souple, tandis que, respectivement, la deuxième ou la première borne de sortie est agencée sur une face opposée du boitier ou de l'emballage souple, l'accumulateur étant agencé horizontalement de sorte que sa chute par gravité selon ii/ a lieu perpendiculairement à son axe longitudinal.

15. Pack-batterie (P) selon l'une des revendications 1 à 13, les première et deuxième bornes de sortie étant toutes deux agencées sur la même face du boitier ou de l'emballage souple, l'accumulateur étant agencé verticalement de sorte que sa chute par gravité selon ii/ a lieu selon son axe longitudinal.

16. Pack-batterie (P) selon l'une des revendications précédentes, chaque accumulateur comprenant un BMS fixé sur le boitier ou l'emballage souple de l'accumulateur et alimenté électriquement par ce dernier.

17. Pack-batterie (P) selon l'une des revendications précédentes, comprenant une structure en nid d'abeille (101) comprenant une pluralité de logements (102) adaptés chacun pour guider un accumulateur chutant par gravité, chaque logement étant susceptible d'être rempli par un liquide caloporteur au moins une fois la chute de l'accumulateur réalisée, afin de refroidir ce dernier.

18. Pack-batterie (P) selon la revendication 17, le liquide caloporteur étant celui d'un circuit de refroidissement du pack-batterie, ou un liquide indépendant dudit circuit de refroidissement dont l'amenée dans chaque logement est pilotée par le BMS du pack-batterie, ou un liquide résultant du changement d'état d'un matériau à changement de phase (MCP) obtenu par l'échauffement de l'accumulateur.

19. Pack-batterie selon l'une des revendications précédentes, dans lequel chaque batterie ou accumulateur est une batterie ou accumulateur de type Li-ion comprenant:
- un matériau d'électrode(s) négative(s) choisi dans le groupe comportant le graphite, le lithium, l'oxyde de titanate Li₄TiO₅O₁₂;
- un matériau d'électrode(s) positive(s) choisi dans le groupe comportant LiFePO₄, LiCoO₂, LiNi_{0.33}Mn_{0.33}Co_{0.33}O₂.

## Patentansprüche

1. Batteriepack (P), umfassend:
- eine Mehrzahl von elektrochemischen Batterien oder Akkus (A1-An), jeweils umfassend:
• ein Gehäuse (6) oder eine flexible Umhüllung,
• eine erste Ausgangsklemme (4) und eine zweite Ausgangsklemme (5) mit zur ersten Ausgangsklemme entgegengesetzter Polarität;
wobei mindestens eine der Ausgangsklemmen umfasst:
• ein elektrisch leitfähiges Teil (17),
• eine magnetische Verriegelung (11), die einen Permanentmagneten (12) umfasst;
- mindestens ein ferromagnetisches Teil (15), das fest mit einer elektrischen Verbindungsschiene, Sammelschiene genannt, verbunden ist und eine Schließplatte eines Magnetkreises mit der magnetischen Verriegelung der Ausgangsklemme bildet;
wobei der Batteriepack so konfiguriert ist, dass:
i/ bei einem Normalbetrieb des Akkus die magnetische Anziehungskraft des Permanentmagneten der Ausgangsklemme auf die Schließplatte einer ersten Sammelschiene, in der Konfiguration der geschlossenen Magnetkreise, die mechanische und elektrische Verbindung zwischen der Ausgangsklemme und der ersten Sammelschiene gewährleistet;
ii/ bei einem Ausfall des Akkus, der dessen Überhitzung verursacht, der Permanentmagnet der Ausgangsklemme sich erwärmt und mindestens bis zu einer Temperatur, von der an er seine magnetischen Eigenschaften verliert, bis zur mechanischen Trennung zwischen der Ausgangsklemme und der ersten Sammelschiene, **dadurch gekennzeichnet, dass** die mechanische Trennung ein Abfallen per Schwerkraft des Akkus verursacht.

2. Batteriepack (P) nach Anspruch 1, umfassend:
- mindestens eine elektrisch leitfähige biegsame Zunge (60), die an einem ihrer Enden an einer anderen Sammelschiene oder einem anderen Teil von Sammelschienen befestigt ist, umfassend einen Permanentmagneten;
wobei der Batteriepack so konfiguriert ist, dass:
beim Schritt i/ der Permanentmagnet der biegsamen Zunge von dem der Ausgangsklemme abgestoßen wird, so dass die biegsame Zunge mit der ersten Stromschiene nicht in elektrischem Kontakt sein kann,
beim Schritt ii/ aufgrund des Nichtvorliegens von magnetischer Abstoßung des ausgefallenen Akkus, der abgefallen ist, die elektrische Verbindung zwischen der ersten und der anderen Sammelschiene jeweils über die biegsame Zunge, die dadurch den Nebenschluss des Akkus ausführt.

3. Batteriepack (P) nach einem der vorhergehenden Ansprüche, wobei die Curie-Temperatur des Permanentmagneten so gewählt ist, dass sie zwischen einem Wert nahe 90 % der Selbsterhitzungstemperatur (T1) und einem Wert nahe 110 % der Temperatur des thermischen Durchgehens (T2) der Akkus des Packs liegt.

4. Batteriepack (P) nach einem der vorhergehenden Ansprüche, wobei der Permanentmagnet ein gesinterter Magnet (12) oder ein kunststoffgebundener Magnet (120) ist, wobei der gesinterte Magnet bevorzugt auf Basis von seltenen Erden ist, bevorzugt aus Samarium-Cobalt oder Neodym-Eisen-Bor, oder bevorzugt aus Ferrit oder bevorzugt aus Aluminium-Nickel-Cobalt-Legierung, wobei der kunststoffgebundene Magnet bevorzugt auf Basis von seltenen Erden ist, bevorzugt aus Samarium-Cobalt oder Neodym-Eisen-Bor, oder aus Ferrit.

5. Batteriepack (P) nach einem der vorhergehenden Ansprüche, wobei mindestens eine der beiden Ausgangsklemmen jedes Akkus mindestens ein zweites ferromagnetisches Teil umfasst, das um das elektrisch leitfähige Teil herum oder innerhalb des elektrisch leitfähigen Teils angeordnet ist, wobei das zweite ferromagnetische Teil in der Schließkonfiguration des Magnetkreises durch die Schließplatte geschlossen wird.

6. Batteriepack (P) nach Anspruch 5 in Kombination mit Anspruch 4, umfassend mindestens ein drittes ferromagnetisches Teil (140), das um das zweite ferromagnetische Teil (14) herum angeordnet ist und dabei eine ringförmige Aufnahme bildet, in der ein kunststoffgebundener Magnet aufgenommen ist, wobei die Spule innerhalb des ersten ferromagnetischen Teils angeordnet ist.

7. Batteriepack (P) nach einem der vorhergehenden Ansprüche, wobei jedes ferromagnetische Teil aus Weicheisen ist.

8. Batteriepack (P) nach einem der vorhergehenden Ansprüche, wobei jede biegsame Zunge aus Kupfer-Beryllium ist.

9. Batteriepack (P) nach einem der vorhergehenden Ansprüche, wobei jedes elektrisch leitfähige Teil (17) jeder Verriegelung aus demselben Material wie eine Akku-Ausgangsklemme ist.

10. Batteriepack (P) nach einem der vorhergehenden Ansprüche, wobei jedes elektrisch leitfähige Teil (17) jeder Verriegelung aus Aluminium oder aus Kupfer ist.

11. Batteriepack (P) nach einem der vorhergehenden Ansprüche, umfassend mindestens eine elektrisch leitfähige Wellenscheibe oder Fächerscheibe (18), die derart angeordnet ist, dass sie in der Schließkonfiguration der Verbindungsmagnetkreise einen elektrischen Kontakt zwischen der mit einer Verriegelung versehenen Ausgangsklemme und einer der Sammelschienen gewährleistet.

12. Batteriepack (P) nach einem der Ansprüche 2 bis 10, umfassend mindestens eine elektrisch leitfähige Wellenscheibe oder Fächerscheibe (18), die derart angeordnet ist, dass sie in der Schließkonfiguration der Nebenschlussmagnetkreise einen elektrischen Kontakt zwischen der Zunge und einer der Sammelschienen gewährleistet.

13. Batteriepack (P) nach Anspruch 11 oder 12, wobei jede Scheibe aus einer Kupfer-Phosphor-Legierung ist.

14. Batteriepack (P) nach einem der vorhergehenden Ansprüche, wobei die erste oder die zweite Ausgangsklemme auf einer Seite des Gehäuses oder der flexiblen Umhüllung angeordnet ist, während die zweite beziehungsweise die erste Ausgangsklemme auf einer entgegengesetzten Seite des Gehäuses oder der flexiblen Umhüllung angeordnet ist, wobei der Akku horizontal angeordnet ist, so dass sein Abfallen per Schwerkraft gemäß ii/ senkrecht zu seiner Längsachse stattfindet.

15. Batteriepack (P) nach einem der Ansprüche 1 bis 13, wobei die erste und zweite Ausgangsklemme beide auf derselben Seite des Gehäuses oder der flexiblen Umhüllung angeordnet sind, wobei der Akku vertikal angeordnet ist, so dass sein Abfallen per Schwerkraft gemäß ii/ entlang seiner Längsachse stattfindet.

16. Batteriepack (P) nach einem der vorhergehenden Ansprüche, wobei jeder Akku ein BMS umfasst, das an dem Gehäuse oder der flexiblen Umhüllung des Akkus befestigt ist und von Letzterem elektrisch versorgt wird.

17. Batteriepack (P) nach einem der vorhergehenden Ansprüche, umfassend eine Wabenstruktur (101), die eine Vielzahl von Aufnahmen (102) umfasst, die jeweils in der Lage sind, einen per Schwerkraft abfallenden Akku zu führen, wobei jede Aufnahme geeignet ist, zumindest nach dem erfolgten Abfallen des Akkus mit einer Wärmeträgerflüssigkeit gefüllt zu werden, um Letzteren zu kühlen.

18. Batteriepack (P) nach Anspruch 17, wobei die Wärmeträgerflüssigkeit die eines Kühlkreises des Batteriepacks oder eine vom Kühlkreis unabhängige Flüssigkeit ist, deren Zuführung in jede Aufnahme durch das BMS des Batteriepacks gesteuert wird, oder eine Flüssigkeit, die aus der Zustandsänderung eines Phasenwechselmaterials (PCM) resultiert, die durch die Erwärmung des Akkus erhalten wird.

19. Batteriepack nach einem der vorhergehenden Ansprüche, wobei jede Batterie oder jeder Akku eine Li-Ionen-Batterie oder ein Li-Ionen-Akku ist, umfassend:
- ein Material der negativen Elektrode(n), das aus der Gruppe gewählt ist, die Graphit, Lithium, Titanatoxid Li₄TiO₅O₁₂ beinhaltet;
- ein Material der positiven Elektrode(n), das aus der Gruppe gewählt ist, die LiFePO₄, LiCoO₂, LiNi_{0.33}Mn_{0.33}Co_{0.33}O₂ beinhaltet.

## Claims

1. A battery pack (P) comprising:
- a plurality of electrochemical batteries or accumulators (A1-An), each comprising:
• a housing (6) or a flexible packaging,
• a first output terminal (4) and a second output terminal (5) of an opposite polarity to the first output terminal;
at least one of the output terminals comprising:
• an electrically conductive part (17),
• a magnetic lock (11) comprising a permanent magnet (12);
- at least one ferromagnetic part (15) secured to an electrical connecting bar, called busbar, forming a closure plate of a magnetic circuit with the magnetic lock of the output terminal;
the battery pack being configured such that:
i/ in normal operation of the accumulator, the magnetic attraction force of the permanent magnet of the output terminal on the closure plate of a first busbar, in the closed magnetic circuit configuration, ensures the mechanical and electrical connection between the output terminal and the first busbar,
ii/ upon a failure of the accumulator provoking an overheating thereof, the permanent magnet of the output terminal heats up and at least to a temperature from which it loses its magnetic properties, to the point of mechanical disconnection between the output terminal and the first busbar, **characterized in that** the disconnection causes the accumulator to drop through gravity.

2. The battery pack (P) according to Claim 1, comprising:
- at least one flexible electrically conductive blade (60) fixed at one of its ends to another busbar or other portion of busbars, comprising a permanent magnet;
the battery pack being configured so that:
during step i/, the permanent magnet of the flexible blade is repelled by that of the output terminal such that the flexible blade cannot be in electrical contact with the first busbar,
during step ii/, because of the absence of magnetic repulsion of the faulty accumulator having fallen, the electrical connection between the first and the other busbar through respectively the flexible blade, which realizes hence the shunt of the accumulator.

3. The battery pack (P) according to Claim 1, the Curie temperature of the permanent magnet being chosen to be between a value close to 90% of the self-heating temperature (T1) and a value close to 110% of the thermal runaway temperature (T2) of the pack accumulators.

4. The battery pack (P) according to one of the preceding claims, the permanent magnet being a sintered magnet (12) or a plasto-magnet (120), the sintered magnet being preferably based on rare earths, preferably samarium-cobalt or neodymium-iron-boron, or made of ferrite or made of aluminum-nickel cobalt alloy, the plastomagnet being preferably based on rare earths, preferably samarium-cobalt, or neodymium-iron-boron or made of ferrite.

5. The battery pack (P) according to one of the preceding claims, at least one of the two output terminals comprising at least one second ferromagnetic part arranged around or inside the electrically conductive part, the second ferromagnetic part being closed by the closure plate in the configuration of closure of the magnetic circuit.

6. The battery pack (P) according to Claim 5 in combination with Claim 4, comprising at least a third ferromagnetic part (140) arranged around the second ferromagnetic part (14) forming an annular housing in which is housed a plasto-magnet, the coil being arranged inside the first ferromagnetic part.

7. The battery pack (P) according to one of the preceding claims, each ferromagnetic part being made of soft iron.

8. The battery pack (P) according to one of the preceding claims, each flexible blade being made of copper-beryllium.

9. The battery pack (P) according to one of the preceding claims, each electrically conductive part (17) of each lock being made of the same material as an accumulator output terminal.

10. The battery pack (P) according to one of the preceding claims, each electrically conductive part (17) of each lock being made of aluminum or of copper.

11. The battery pack (P) according to one of the preceding claims, comprising an electrically conductive crinkle washer (18) or tooth lockwasher, arranged such that, in the configuration of closure of the magnetic connection circuits, it ensures an electrical contact between one of the output terminal equipped with a lock and one of the busbars.

12. The battery pack (P) according to one of claims 2 to 10, comprising an electrically conductive crinkle washer (18) or tooth lockwasher, arranged such that, in the configuration of closure of the magnetic shunt circuits, it ensures an electrical contact between the blade and one of the busbars.

13. The battery pack (P) according to Claim 11 or Claim 12, each washer being made of copper-phosphorus alloy.

14. The battery pack (P) according to one of the preceding claims, the first or second output terminals being arranged on one face of the case or the flexible packaging, while, respectively, the second or the first output terminal is arranged on an opposite face of the case or the flexible packaging, the accumulator being arranged horizontally so that its fall by gravity along ii / takes place perpendicularly to its longitudinal axis.

15. The battery pack (P) according to one of the claims 1 to 13, the first and second output terminals being both arranged on the same face of the housing or the flexible packaging, the accumulator being arranged vertically so that its fall by gravity along ii / takes place along its longitudinal axis.

16. The battery pack (P) according to one of the preceding claims, wherein each accumulator comprises a BMS fixed on the housing or the flexible packaging of the accumulator and electrically powered by the latter.

17. The battery pack (P) according to one of the preceding claims, comprising a honeycomb structure (101) comprising a plurality of recesses (102) each suitable for receiving an accumulator falling by gravity; each recess being capable of being filled with a heat transfer liquid at least once the fall of the accumulator carried out, in order to cool the latter.

18. The battery pack according to Claim 17, wherein the heat transfer liquid is that of a cooling circuit of the battery pack, or a liquid independent of said cooling circuit, the supply of which in each housing is controlled by the BMS of the battery pack, or a liquid resulting from the change of state of a phase change material (PCM) obtained by the heating of the accumulator.

19. The battery pack according to according to one of the preceding claims, wherein each battery or accumulator is a battery or accumulator of the Li-ion type comprising:
- a negative electrode(s) material chosen from the group comprising graphite, lithium, titanium oxide Li4TiO5O12;
- a positive electrode(s) material chosen from the group comprising LiFePO4, LiCoO2, LiNi0.33Mn0.33Co0.33O2.
